(19) Europäisches Patentamt / European Patent Office / Office européen des brevets

(11) **EP 1 988 639 B1**

(12) **EUROPEAN PATENT SPECIFICATION**

(45) Date of publication and mention
of the grant of the patent:
**11.01.2012 Bulletin 2012/02**

(21) Application number: **06833392.1**

(22) Date of filing: **27.11.2006**

(51) Int Cl.:
*H04B 1/16* (2006.01)     *H03D 1/22* (2006.01)
*H04B 1/26* (2006.01)     *H04L 27/00* (2006.01)
*H04B 1/30* (2006.01)

(86) International application number:
**PCT/JP2006/323588**

(87) International publication number:
**WO 2007/097084 (30.08.2007 Gazette 2007/35)**

(54) **RECEIVING APPARATUS**

EMPFANGSVORRICHTUNG

APPAREIL DE RÉCEPTION

(84) Designated Contracting States:
**DE FR GB**

(30) Priority: **24.02.2006   JP 2006048364**

(43) Date of publication of application:
**05.11.2008   Bulletin 2008/45**

(73) Proprietor: **Pioneer Corporation
Kanagawa 212-0031 (JP)**

(72) Inventor: **KUBUKI, Toshiakic/o Kawagoe Koujou
Kawagoe-shi, Saitama 3508555 (JP)**

(74) Representative: **Popp, Eugen
Meissner, Bolte & Partner GbR
Postfach 86 06 24
81633 München (DE)**

(56) References cited:
**EP-A2- 0 102 662     JP-A- 11 122 318
JP-A- 2005 151 016     US-A- 4 635 279**

**Description**

**TECHNICAL FIELD**

The present invention relates to a receiver for synchronous detection of modulated signals and the like.

**BACKGROUND ART**

Conventionally, a number of receivers in information and communication systems employ the PLL (Phase Locked Loop) synchronous detection when demodulating a received signal into a demodulated signal.

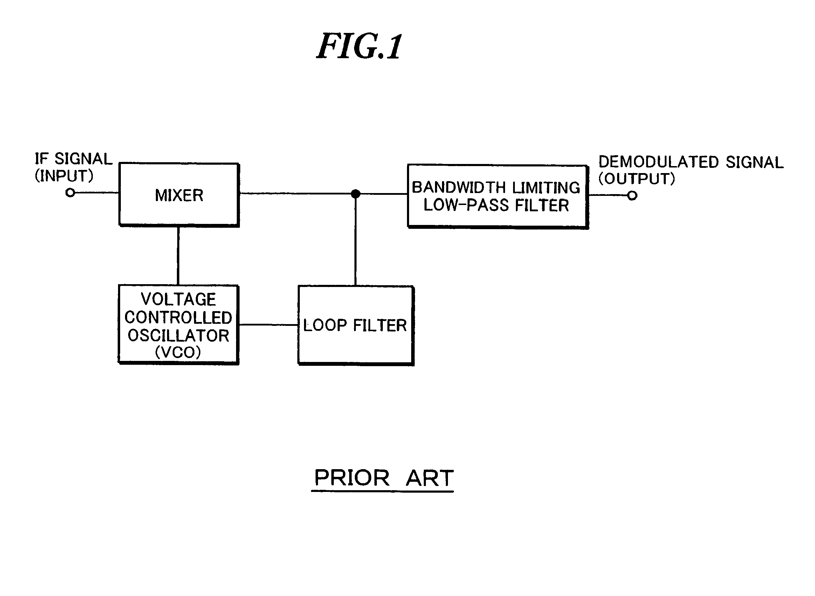

As shown in Fig. 1, in the PLL synchronous detection, an IF signal (modulated signal) at an intermediate frequency and an oscillated signal produced in a voltage controlled oscillator (VCO) are mixed in a mixer. The direct current component of the mixed signal (or the phase difference between the oscillated signal and the carrier) is detected in a low-pass filter (loop filter), so that PLL control is provided to the voltage controlled oscillator (VCO) to lock the oscillated signal to the carrier of the IF signal. Then, when the carrier of the IF signal and the oscillated signal from the voltage controlled oscillator are in phase with each other, the demodulated signal is to be delivered from a bandwidth limiting low-pass filter.

The most relevant prior art is Patent Document US 4 635 279 A. This discloses an arrangement for coherently generating sinusoids of different frequencies, and angle modulation data receiver using the arrangement. More specifically, data signals are angle-modulated onto a carrier in such a fashion as to suppress the carrier. Such modulation may be BPSK, MSK, QPSK, or OPQSK. The carrier may be subject to anomalous phase shifts, as may occur for example when the transmitter and receiver are in relative motion. In order to regenerate the carrier, the received signal is frequency-doubled (or quadrupled in the case of QPSK). The frequency doubled signal is demodulated by means of locally generated double-frequency demodulating signals to form baseband I and Q signals. The I and Q baseband information is evaluated over a predetermined time interval to establish the relative phase between the carrier of the double frequency signal and the double-frequency demodulating signal. At the end of each predetermined interval, the phase of the double-frequency demodulating signal is adjusted to be in-phase with the double-frequency carrier. The double-frequency demodulating signals are generated by addressing memories by at least parts of a recurrent digital sawtooth signal. Carrier-frequency demodulating signals are simultaneously generated by addressing other memories by means of the recurrent digital sawtooth signal. Because of the simultaneous addressing of the memories, the relative phases of the double-frequency and carrier-frequency signals are established by the programming of the memories. When the double-frequency demodulating signals are forced to the correct phase for demodulating the double-frequency signals at the end of each predetermined time interval, the carrier-frequency demodulating signals are also forced to correct phase for coherent low-noise demodulation of the data. The carrier-frequency demodulating signals are used to demodulate data modulated carrier delayed by the predetermined time interval.

**DISCLOSURE OF THE INVENTION**

**PROBLEMS TO BE SOLVED BY THE INVENTION**

To perform the aforementioned PLL synchronous detection, it is necessary to provide the PLL loop with an increased loop bandwidth relative to the modulation bandwidth. This loop bandwidth is generally determined by the characteristics of the aforementioned loop filter. Thus, for example, increasing the cutoff frequency of the loop filter to expand the loop bandwidth may cause degradation in resistance to wide-band jitter. On the other hand, lowering the cutoff frequency of the loop filter to enhance the resistance to jitter may cause deterioration in trackability making it difficult to perform the synchronous detection as desired.

As such, there is a trade-off between narrowing the loop bandwidth and expanding the loop bandwidth relative to the modulation bandwidth, for example, to prevent adverse effects caused by jitter or the like. It was thus difficult to rely on the optimal design of the loop bandwidth in order to perform synchronous detection with good trackability.

The present invention was developed in view of such conventional problems. It is therefore an object of the present invention to provide a receiver which makes full use of good trackability, for example, for synchronous detection of modulated signals.

It is another object of the present invention to provide a novel receiver which performs synchronous detection and the like without a PLL loop.

**MEANS FOR SOLVING THE PROBLEMS**

The invention according to claim 1 provides a receiver which performs synchronous detection of a modulated signal. The receiver includes: orthogonal signal generation means for producing, from the modulated signal, a first signal and a second signal having phases orthogonal to each other; carrier generation means for producing a trigonometric ratio of the first signal and the second signal and for detecting at least one sign of the first signal and the second signal, so that the trigonometric ratio and the sign are used to produce a first regenerated carrier signal and a second regenerated carrier signal having phases orthogonal to each other; frequency shifter means for shifting the first and second regenerated carrier signals by a predetermined angular frequency to produce a first shifted signal and a second shifted signal; and combiner means for combining the first signal, the second signal, and the first and second shifted signals, thereby converting each carrier component of the first signal and the second signal to a carrier at the predetermined angular frequency to produce a first regenerated-modulated signal and a second regenerated-modulated signal. The receiver is characterized by performing the synchronous detection based on the first and second regenerated-modulated signals.

The invention according to claim 2 provides a receiver which performs synchronous detection of a modulated signal. The receiver includes: orthogonal signal generation means for producing, from the modulated signal, a first signal and a second signal having phases orthogonal to each other; frequency shifter means for shifting the first signal and the second signal by a predetermined angular frequency to produce a first shifted signal and a second shifted signal; carrier generation means for producing a trigonometric ratio of the first and second shifted signals and for detecting at least one sign of the first and second shifted signals, so that the trigonometric ratio and the sign are used to produce a first regenerated carrier signal and a second regenerated carrier signal having phases orthogonal to each other; and combiner means for combining the first signal, the second signal, and the first and second regenerated carrier signals, thereby converting each carrier component of the first signal and the second signal to a carrier at the predetermined angular frequency to produce a first regenerated-modulated signal and a second regenerated-modulated signal. The receiver is characterized by performing the synchronous detection based on the first and second regenerated-modulated signals.

The invention according to claim 3 provides a receiver which performs synchronous detection of a modulated signal. The receiver includes: orthogonal signal generation means for producing, from the modulated signal, a first signal and a second signal having phases orthogonal to each other; carrier generation means for producing a trigonometric ratio of the first signal and the second signal and for detecting at least one sign of the first signal and the second signal, so that the trigonometric ratio and the sign are used to produce a first regenerated carrier signal and a second regenerated carrier signal having phases orthogonal to each other; frequency shifter means for shifting the first signal and the second signal by a predetermined angular frequency to produce a first shifted signal and a second shifted signal; and combiner means for combining the first and second shifted signals, and the first and second regenerated carrier signals, thereby converting each carrier component of the first and second shifted signals to a carrier at the predetermined angular frequency to produce a first regenerated-modulated signal and a second regenerated-modulated signal. The receiver is characterized by performing the synchronous detection based on the first and second regenerated-modulated signals.

The invention according to claim 4 provides a receiver which performs synchronous detection of a modulated signal. The receiver includes: orthogonal signal generation means for producing, from the modulated signal, a first signal and a second signal having phases orthogonal to each other; carrier generation means for producing a trigonometric ratio of the first signal and the second signal and for detecting at least one sign of the first signal and the second signal, so that the trigonometric ratio and the sign are used to produce a first regenerated carrier signal and a second regenerated carrier signal having phases orthogonal to each other; combiner means for combining the first signal, the second signal, and the first and second regenerated carrier signals, thereby producing an envelope signal indicative of an envelope of a combined component of the first signal and the second signal; and frequency shifter means for modulating the envelope signal based on signals having a predetermined angular frequency and having phases orthogonal to each other, thereby producing a first regenerated-modulated signal and a second regenerated-modulated signal. The receiver is characterized by performing the synchronous detection based on the first and second regenerated-modulated signals.

## BRIEF DESCRIPTION OF THE DRAWINGS

Fig. 1 is an explanatory view illustrating the basic principle of the conventional PLL synchronous detection.
Fig. 2 shows block diagrams illustrating the configuration of a receiver according to a first embodiment and a second embodiment of the present invention, respectively.
Fig. 3 shows block diagrams illustrating the configuration of a receiver according to a third embodiment and a fourth embodiment of the present invention, respectively.
Fig. 4 is a block diagram illustrating the configuration of orthogonal signal generation means according to a first example.
Fig. 5 is a block diagram illustrating the configuration of carrier generation means according to a second example.
Fig. 6 is an explanatory view illustrating the function of the carrier generation means shown in Fig. 5.

Fig. 7 is a block diagram illustrating the configuration of carrier generation means according to a third example.

Fig. 8 is an explanatory view illustrating the function of the carrier generation means shown in Fig. 7.

Fig. 9 is a block diagram illustrating the configuration of carrier generation means according to a fourth example.

Fig. 10 is an explanatory view illustrating the function of the carrier generation means shown in Fig. 9.

Fig. 11 is a block diagram illustrating the configuration of carrier generation means according to a fifth example.

Fig. 12 is a block diagram illustrating the configuration of frequency shifter means according to a sixth example.

Fig. 13 is a block diagram illustrating the configuration of combiner means according to a seventh example.

Fig. 14 is a block diagram illustrating the configuration of demodulator means according to an eighth example.

Fig. 15 is a block diagram illustrating the configuration of demodulator means according to a ninth example.

## BEST MODE FOR CARRYING OUT THE INVENTION

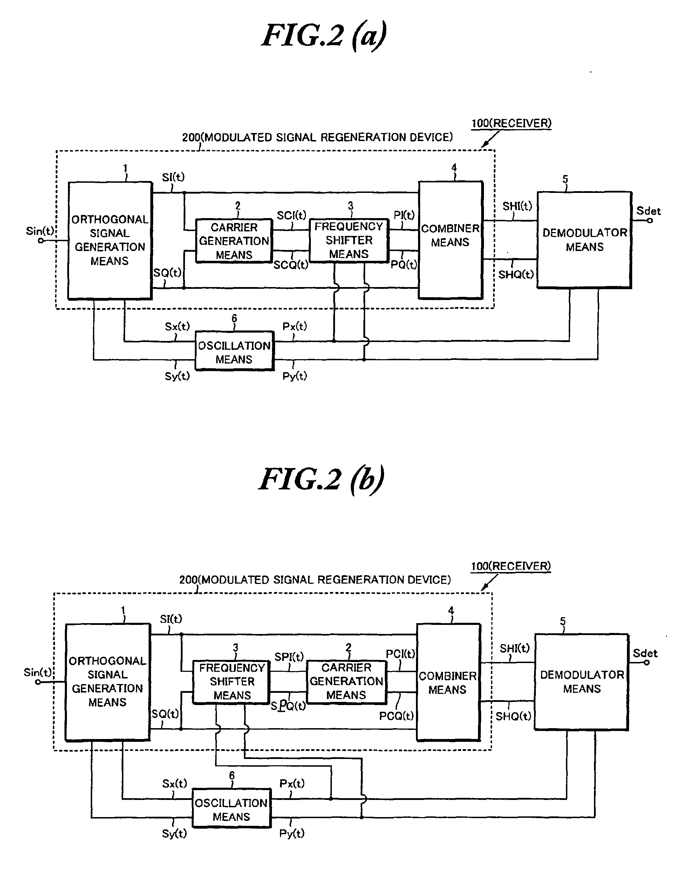

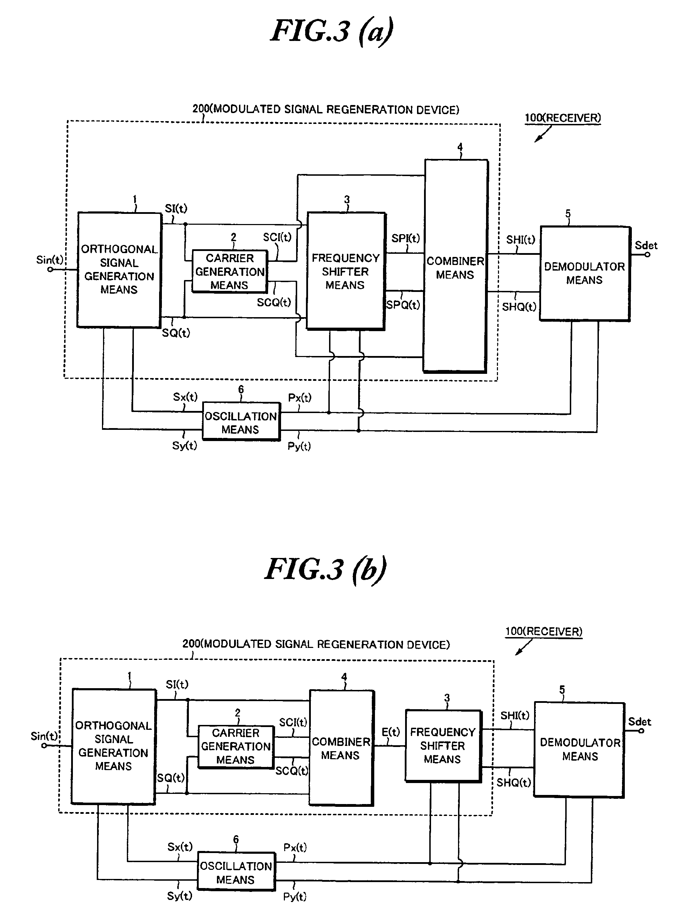

A description will now be made to a receiver of the present invention in accordance with the embodiments with reference to the drawings. Figs. 2(a) and (b) show a block diagram illustrating the configuration of a receiver according to first and second embodiments, respectively. Figs. 3 (a) and (b) show a block diagram illustrating the configuration of a receiver according to third and fourth embodiments, respectively.

[First embodiment]

To begin with, with reference to Fig. 2 (a), a description will be made to a receiver according to a first embodiment.

A receiver 100 of the present embodiment is configured to include a modulated signal regeneration device 200, demodulator means 5, and oscillation means 6. The modulated signal regeneration device 200 is configured to include orthogonal signal generation means 1, carrier generation means 2, frequency shifter means 3, and combiner means 4.

The orthogonal signal generation means 1 receives an IF signal (modulated signal) Sin (t) produced in a frontend section (not shown) or the like. Then, from the modulated signal Sin(t), produced are a first signal (hereinafter referred to as the "I signal") SI and a second signal (hereinafter referred to as the "Q signal") SQ, which are orthogonal to each other with a phase difference of 90 degrees ($\pi/2$ radian) therebetween.

More specifically, for example, for convenience of explanation, let the modulated signal Sin (t) be expressed by a general formula of a baseband signal f (t) and a carrier g (t) that are shown in Equation (1a) below. The orthogonal signal generation means 2 mixes reference signals Sx (t) and Sy (t), which are expressed by Equations (1b) and (1c) below having phases orthogonal to each other, with the modulated signal Sin(t). From the mixed signals X(t) and Y(t), a sideband wave component is extracted which is shifted toward an angular frequency (wo - wr), thereby producing the I signal SI and the Q signal SQ, which are expressed by Equations (1d) and (le) below having phases orthogonal to each other.

Note that for the modulated signal Sin(t), A is the gain, k and p are the modulation factor and the angular frequency of the baseband signal f(t), respectively, wo and $\theta$ (t) are the angular frequency and the phase of the carrier g(t), respectively, and wr is an appropriate angular frequency of the reference signals Sx(t) and Sy(t).

[Equation 1]

$$S_{in}(t) = f(t) \times g(t) = A(1 + k\cos(pt)) \times \cos(\omega_o t + \theta(t)) \quad \cdots (1a)$$

$$X(t) = S_{in}(t) \times S_x(t) = S_{in}(t) \times \cos(\omega_r t) \quad \cdots (1b)$$

$$Y(t) = S_{in}(t) \times S_y(t) = S_{in}(t) \times \cos(\omega_r t + \pi/2) \quad \cdots (1c)$$

$$SI(t) = 0.5 \times f(t) \times \cos((\omega_o - \omega_r)t + \theta(t)) \quad \cdots (1d)$$

$$SQ(t) = 0.5 \times f(t) \times \sin((\omega_o - \omega_r)t + \theta(t)) \quad \cdots (1e)$$

The carrier generation means 2 is configured in the same manner as a "carrier regeneration device" disclosed in "Japanese Patent Application No. 2006-30991" previously filed by the present applicant. The carrier generation means 2 produces a predetermined trigonometric ratio R from the instantaneous amplitude of the I signal SI(t) and the Q signal SQ(t) and performs an inverse trigonometric operation on the trigonometric ratio R, thereby producing a phase $\alpha$ (t) for the trigonometric ratio R. Furthermore, a phase correction is made to the phase $\alpha$ (t) to yield a correct phase $\varphi$ (t) which

satisfies the relation between the polarities (plus or minus sign) of each instantaneous amplitude of the I signal SI (t) and the Q signal SQ (t). The phase φ (t) is then employed as a parameter to produce a first regenerated carrier signal SCI(t) and a second regenerated carrier signal SCQ(t), which have phases orthogonal to each other.

That is, the carrier generation means 2 produces the phase $\alpha$(t) by performing one of the following inverse trigonometric operations: the inverse tangent operation for a "tangent" trigonometric ratio R, the inverse sine operation for a "sine" trigonometric ratio R, the inverse secant operation for a "secant" trigonometric ratio R, the inverse cotangent operation for a "cotangent" trigonometric ratio R, the inverse cosine operation for a "cosine" trigonometric ratio R, and the inverse cosecant operation for "cosecant". Furthermore, a phase correction is made to the phase a (t) to yield the phase φ (t) which matches the polarity (sign) of the I signal SI(t) and the Q signal SQ(t). Then, based on the phase φ (t), the regenerated carrier signals SCI (t) and SCQ (t) are produced which are expressed by Equations (2a) and (2b) below having phases orthogonal to each other.

[Equation 2]

$$SCI(t) = cos((\omega_o - \omega_r) t + \theta (t)) \qquad \cdots (2a)$$

$$SCQ(t) = sin((\omega_o - \omega_r) t + \theta (t)) \qquad \cdots (2b)$$

The frequency shifter means 3 follows a predetermined algorithm using the addition theorem for the trigonometric functions to combine (in an arithmetic operation) the regenerated carrier signals SCI(t) and SCQ(t) with oscillated signals Px(t) and Py(t) of an angular frequency ωs, which are supplied from the oscillation means 6 and orthogonal to each other with a phase difference of π/2 therebetween. This allows for shifting the regenerated carrier signals SCI(t) and SCQ(t) by the angular frequency ws to produce first and second shifted signals PI (t) and PQ (t) as expressed by Equations (3a) and (3b) below.

[Equation 3]

$$PI(t) = cos((\omega_o - \omega_r + \omega_s) t + \theta (t)) \qquad \cdots (3a)$$

$$PQ(t) = sin((\omega_o - \omega_r + \omega_s) t + \theta (t)) \qquad \cdots (3b)$$

The combiner means 4 follows a predetermined algorithm using the addition theorem for the trigonometric functions to combine (in an arithmetic operation) the I signal SI (t), the Q signal SQ(t), and the shifted signals PI (t) and PQ(t) . This allows for producing regenerated-modulated signals SHI (t) and SHQ (t) expressed by Equations (4a) and (4b) below.

That is, the combinermeans 4 combines the I signal SI (t) having a carrier component expressed by cos ((ωo-ωr) t + θ (t) ), the Q signal SQ (t) having a carrier component expressed by sin ((ωo - ωr) t + θ (t)), , the shifted signal PI (t) expressed by cos ( (ωo - ωr + ωs) t + θ (t) ), and the shifted signal PQ(t) expressed by sin ((ωo - ωr + ωs)t + θ (t)). This allows for converting the carrier component of the I signal SI(t) and the Q signal SQ(t) to a carrier of the angular frequency ωs, and then delivering both the resulting signals as the regenerated-modulated signals SHI(t) and SHQ(t).

[Equation 4]

$$SHI(t) = SI(t) \times PI(t) + SQ(t) \times PQ(t)$$
$$= 0.5 \times f(t) \times \cos((\omega_o - \omega r)t + \theta(t)) \times \cos((\omega_o - \omega r + \omega s)t + \theta(t))$$
$$+ 0.5 \times f(t) \times \sin((\omega_o - \omega r)t + \theta(t)) \times \sin((\omega_o - \omega r + \omega s)t + \theta(t))$$
$$= 0.5 \times f(t) \times \cos(\omega_s t)$$
$$= 0.5 \times A \times (1 + k \cos(pt)) \times \cos(\omega_s t) \qquad \cdots (4a)$$

$$SHQ(t) = SI(t) \times PQ(t) - SQ(t) \times PI(t)$$
$$= 0.5 \times f(t) \times \cos((\omega_o - \omega r)t + \theta(t)) \times \sin((\omega_o - \omega r + \omega s)t + \theta(t))$$
$$- 0.5 \times f(t) \times \sin((\omega_o - \omega r)t + \theta(t)) \times \cos((\omega_o - \omega r + \omega s)t + \theta(t))$$
$$= 0.5 \times f(t) \times \sin(\omega_s t)$$
$$= 0.5 \times A \times (1 + k \cos(pt)) \times \sin(\omega_s t) \qquad \cdots (4b)$$

Using the oscillated signals Px(t) and Py(t) as a carrier, the demodulator means 5 demodulates the regenerated-modulated signals SHI(t) and SHQ (t) based on the oscillated signals Px(t) and Py(t), thereby producing a demodulated signal Sdet.

As described above, according to the receiver 100 of the present embodiment, the modulated signal regeneration device 200 allows the orthogonal signal generation means 1 to produce, from the modulated signal Sin(t), the I signal SI (t) and the Q signal SQ(t) having phases orthogonal to each other. Then, the carrier generation means 2 produces a correct phase φ (t) based on the trigonometric ratio R and the sign of the I signal SI(t) and the Q signal SQ (t) to produce the regenerated carrier signals SCI (t) and SCQ(t) which are expressed by Equations (2a) and (2b) above with the phase φ(t) employed as a parameter. Then, the frequency shifter means 3 uses the oscillated signals Px (t) and Py (t) at the predetermined angular frequency ωs to produce the shifted signals PI(t) and PQ(t) which are obtained by shifting the angular frequency of the regenerated carrier signals SCI(t) and SCQ(t). Then, the combiner means 4 combines the I signal SI(t), the Q signal SQ(t), and the shifted signals PI(t) and PQ(t), thereby producing the regenerated-modulated signals SHI (t) and SHQ (t) which are obtained by converting the carrier component of the I signal SI (t) and the Q signal SQ(t) to a carrier of the angular frequency ωs. The regenerated-modulated signals SHI (t) and SHQ (t) are then supplied to the demodulator means 5.

As such, the carrier generation means 2 and the frequency shifter means 3 convert the carrier component of the I signal SI (t) and the Q signal SQ(t) possessing the baseband signal f (t) component of the modulated signal Sin (t) to a carrier of the angular frequency ωs, thereby producing the regenerated-modulated signals SHI (t) and SHQ(t). This allows the demodulator means 5 to demodulate the regenerated-modulated signals SHI (t) and SHQ (t) using, as a carrier, the oscillated signals Px(t) and Py(t) which have been generated at the oscillation means 6 in the receiver 100.

Furthermore, there may occur changes in the phase θ (t) of the I signal SI (t) and the Q signal SQ (t), frequency shifts, or frequency variations therein. Even in this case, the carrier component of the I signal SI(t) and the Q signal SQ (t) can be converted to a carrier of the angular frequency ωs, thereby producing the regenerated-modulated signals SHI (t) and SHQ(t) with stabilized carrier frequency. Accordingly, when the regenerated-modulated signals SHI(t) and SHQ (t) are demodulated using the oscillated signals Px(t) and Py(t) as a carrier, the demodulator means 5 can eliminate the effects due to the aforementioned changes in the phase θ (t), frequency shifts, and frequency variations, and can produce the demodulated signal Sdet with high accuracy.

Furthermore, the receiver 100 of the present embodiment produces the regenerated-modulated signals SHI (t) and SHQ (t) and reproduces the demodulated signal Sdet without including a feedback loop system as for the conventional PLL synchronous detection. This allows for making full use of good trackability for the modulated signal Sin (t). Additionally, this also allows for eliminating the necessity for making difficult adjustments such as the adjustment of the loop bandwidth of the PLL loop system. Furthermore, the structure can be simplified as compared with that for the PLL synchronous detection.

Then, the receiver 100 of the present embodiment can make use of advantageous effects for synchronous detection of a modulated signal provided by linear modulation. For example, it is possible to perform synchronous detection of a modulated signal provided by AM modulation or AM stereo modulation.

Note that the modulated signal regeneration device 200 of the present embodiment described above allows the orthogonal signal generation means 1 to provide those sideband wave components, which are obtained by shifting the modulated signal Sin(t) toward the angular frequency ($\omega$o - $\omega$r) and have phases orthogonal to each other, as the I signal SI (t) and the Q signal SQ (t) . However, as expressed by Equations (5a) and (5b) below, those sideband wave components which are obtained by shifting the modulated signal Sin (t) toward an angular frequency ($\omega$o + $\omega$r) and have phases orthogonal to each other may also be employed as the I signal SI(t) and the Q signal SQ(t).

[Equation 5]

$$SI(t) = 0.5 \times f(t) \times cos((\omega_o + \omega_r) t + \theta(t)) \quad \cdots (5a)$$

$$SQ(t) = 0.5 \times f(t) \times sin((\omega_o + \omega_r) t + \theta(t)) \quad \cdots (5b)$$

Furthermore, the angular frequency of the oscillated signals Px(t) and Py(t) from the oscillation means 6 has a plus angular frequency $\omega$s, but may also have a minus angular frequency (-$\omega$s).

Furthermore, the receiver 100 of the present embodiment described above may be formed in hardware such as transistor circuits or LSIs (integrated circuit device). Alternatively, a computer program which provides the same function as the hardware would do may be prepared. Then, DSPs (digital signal processor) or MPUs (microprocessor) may be operated on the computer program, thereby providing so-called software communications (software receptions).

Alternatively, the receiver 100 may be formed of analog circuits or may also be formed of digital circuits with an A/D converter for converting the modulated signal Sin(t) from analog to digital to thereby process digital modulated signals.

[Second embodiment]

Now, with reference to Fig. 2 (b), a description will be made to a receiver according to a second embodiment. Note that in Fig. 2(b), the components which are the same as or equivalent to those of Fig. 2(a) are indicated with the same symbols.

The receiver 100 of the present embodiment is the same as that of the first embodiment except that in the modulated signal regeneration device 200, the carrier generation means 2 and the frequency shifter means 3, which were described in relation to the first embodiment, are exchanged.

The modulated signal regeneration device 200 configured as such allows the orthogonal signal generation means 1 to produce, from the modulated signal Sin (t), the I signal SI (t) and the Q signal SQ (t) having phases orthogonal to each other. Then, the frequency shifter means 3 follows a predetermined algorithm using the addition theorem for the trigonometric functions to combine the I signal SI(t), the Q signal SQ (t), and the oscillated signals Px(t) and Py(t) having phases orthogonal to each other. As expressed by Equations (6a) and (6b) below, this allows for producing a first shifted signal SPI (t) obtained by shifting the angular frequency of the I signal SI(t) and a second shifted signal SPQ (t) obtained by shifting the angular frequency of the Q signal SQ (t).

[Equation 6]

$$SPI(t) = 0.5 \times f(t) \times cos((\omega_o - \omega_r + \omega_s) t + \theta(t)) \quad \cdots (6a)$$

$$SPQ(t) = 0.5 \times f(t) \times sin((\omega_o - \omega_r + \omega_s) t + \theta(t)) \quad \cdots (6b)$$

Then, the carrier generation means 2 produces a predetermined trigonometric ratio R from the instantaneous amplitude of the shifted signals SPI(t) and SPQ (t), and performs an inverse trigonometric operation on the trigonometric ratio R, thereby producing the phase $\alpha$ (t) for the trigonometric ratio R. Furthermore, a phase correction is made to the phase $\alpha$ (t) to yield a phase $\varphi$ (t) which matches the polarity (plus or minus sign) of the shifted signals SPI (t) and SPQ (t) . The phase $\varphi$ (t) is then employed as a parameter to produce first and second regenerated carrier signals PCI (t) and PCQ (t) having phases orthogonal to each other.

That is, in the present embodiment, the frequency shifter means 3 first produces the shifted signals SPI(t) and SPQ (t) obtained by shifting the angular frequency of the I signal SI(t) and the Q signal SQ (t) . Then, the carrier generation means 2 produces the regenerated carrier signals PCI (t) and PCQ (t), expressed by Equations (7a) and (7b) below, which correspond to each carrier component of the shifted signals SPI (t) and SPQ(t).

[Equation 7]

$$PCI(t) = cos((\omega_o - \omega_r + \omega_s)t + \theta(t)) \quad \cdots (7a)$$

$$PCQ(t) = sin((\omega_o - \omega_r + \omega_s)t + \theta(t)) \quad \cdots (7b)$$

Accordingly, as can be seen clearly from Equations (3a), (3b), (7a), and (7b) above, the present embodiment produces the first and second regenerated carrier signals PCI (t) and PCQ (t) as the first and second shifted signals PI (t) and PQ (t) produced in the first embodiment.

Then, the combiner means 4 follows a predetermined algorithm using the addition theorem for the trigonometric functions to combine the I signal SI (t), the Q signal SQ (t), and the regenerated carrier signals PCI (t) and PCQ (t). This allows for converting the carrier component of the I signal SI(t) and the Q signal SQ (t) to a carrier of the angular frequency $\omega s$, thereby producing the regenerated-modulated signals SHI(t) and SHQ (t) expressed by Equations (4a) and (4b) above. Then, the demodulator means 5 demodulates the regenerated-modulated signals SHI(t) and SHQ (t) based on the oscillated signals Px (t) and Py (t), thereby producing the demodulated signal Sdet.

As described above, as with the first embodiment, the receiver 100 of the present embodiment converts the carrier component of the I signal SI (t) and the Q signal SQ (t) possessing the component of the baseband signal f(t) of the modulated signal Sin(t) to a carrier of the angular frequency $\omega s$, thereby producing the regenerated-modulated signals SHI(t) and SHQ(t). This allows the demodulator means 5 to demodulate the regenerated-modulated signals SHI (t) and SHQ(t) using, as a carrier, the oscillated signals Px(t) and Py(t) which have been generated at the oscillation means 6 in the receiver 100.

Furthermore, there may occur changes in the phase $\theta$ (t) of, frequency shifts, or frequency variations in the I signal SI(t) and the Q signal SQ (t). Even in this case, the carrier component of the I signal SI(t) and the Q signal SQ (t) can be converted to a carrier of the angular frequency $\omega s$, thereby producing the regenerated-modulated signals SHI (t) and SHQ (t) with stabilized carrier frequency. Accordingly, the demodulator means 5 can employ the oscillated signals Px(t) and Py(t) as a carrier to demodulate the regenerated-modulated signals SHI (t) and SHQ (t), thereby eliminating the effects due to the aforementioned changes in the phase $\theta$ (t), frequency shifts, and frequency variations, and producing the demodulated signal Sdet with high accuracy.

Furthermore, the receiver 100 of the present embodiment produces the regenerated-modulated signals SHI (t) and SHQ (t) and reproduces the demodulated signal Sdet without including a feedback loop system as for the conventional PLL synchronous detection. This allows for making full use of good trackability for the modulated signal Sin (t). Additionally, this also allows for eliminating the necessity for making difficult adjustments such as the adjustment of the loop bandwidth of the PLL loop system. Furthermore, the structure can be simplified as compared with that for the PLL synchronous detection.

Then, the receiver 100 of the present embodiment can make use of advantageous effects for synchronous detection of a modulated signal provided by linear modulation. For example, it is possible to perform synchronous detection of a modulated signal provided by AM modulation or AM stereo modulation.

Note that the orthogonal signal generation means 1 may employ the sideband wave components obtained by shifting the modulated signal Sin (t) toward the angular frequency ($\omega o - \omega r$) as the I signal SI(t) and the Q signal SQ (t). Alternatively, those sideband wave components obtained by shifting the modulated signal Sin(t) toward the angular frequency ($\omega o + \omega r$) may also be employed as the I signal SI (t) and the Q signal SQ (t). Furthermore, the angular frequency of the oscillated signals Px (t) and Py (t) from the oscillation means 6 may be employed as a plus angular frequency $\omega s$ or may also be employed as a minus angular frequency ($-\omega s$).

Furthermore, the receiver 100 of the present embodiment described above may be formed in hardware such as transistor circuits or LSIs (integrated circuit device). Alternatively, a computer program which provides the same function as the hardware would do may be prepared. Then, DSPs (digital signal processor) or MPUs (microprocessor) may be operated on the computer program, thereby providing so-called software communications (software receptions) . Furthermore, as with the first embodiment, the receiver 100 may be formed of analog circuits or may also be formed of digital circuits.

[Third embodiment]

Now, with reference to Fig. 3 (a), a description will be made to a receiver according to a third embodiment. Note that in Fig. 3 (a), the components which are the same as or equivalent to those of Figs. 2(a) and 2(b) are indicated with the same symbols.

In the receiver 100 of the present embodiment, the I signal SI(t) and the Q signal SQ (t) are supplied to the carrier generation means 2 and the frequency shifter means 3. Following a predetermined algorithm using the addition theorem for the trigonometric functions, the combiner means 4 combines the first and second regenerated carrier signals SCI (t) and SCQ (t) produced in the carrier generation means 2, and the first and second shifted signals SPI (t) and SPQ (t) produced in the frequency shifter means 3. This allows for producing the first and second regenerated-modulated signals SHI (t) and SHQ (t) for supply to the demodulator means 5.

In the receiver 100 configured as such, the orthogonal signal generation means 1 produces, from the modulated signal Sin (t) , the I signal SI (t) and the Q signal SQ (t) having phases orthogonal to each other. Then, the carrier generation means 2 uses the trigonometric ratio R and the sign of the I signal SI(t) and the Q signal SQ (t) to produce the regenerated carrier signals SCI (t) and SCQ (t), which are in turn used to produce a phase $\omega$ (t). Furthermore, the frequency shifter means 3 follows a predetermined algorithm using the addition theorem for the trigonometric functions to shift the angular frequency of the I signal SI (t) and the Q signal SQ (t) based on the oscillated signals Px(t) and Py (t) supplied from the oscillation means 6. This allows for producing the first and second shifted signals SPI (t) and SPQ (t), which are then supplied to the combiner means 4. Accordingly, the combiner means 4 receives the regenerated carrier signals SCI (t) and SCQ (t) expressed by Equations (2a) and (2b) above and the shifted signals SPI(t) and SPQ (t) expressed by Equations (6a) and (6b) above.

Then, the combiner means 4 follows a predetermined algorithm using the addition theorem for the trigonometric functions to combine the regenerated carrier signals SCI (t) and SCQ (t), and the shifted signals SPI (t) and SPQ (t) . This allows for producing the first and second regenerated-modulated signals SHI (t) and SHQ (t) expressed by Equations (4a) and (4b) above.

That is, the combiner means 4 combines the shifted signal SPI (t) having a carrier component expressed by $\cos ((\omega o - \omega r + \omega s) t + \omega (t)$, the shifted signal SPQ (t) having a carrier component expressed by $\sin ((wo - \omega r + \omega s) t + \theta (t))$, the regenerated carrier signal SCI (t) expressed by $\cos ((wo - \omega r)t + \theta (t))$, and the regenerated carrier signal SCQ (t) expressed by $\sin ((\omega o - \omega r)t + \omega (t))$. This allows for converting the carrier component of the shifted signals SPI (t) and SPQ (t) to a carrier of the angular frequency $\omega s$, and then delivering the resulting signals as the regenerated-modulated signals SHI (t) and SHQ (t).

Then, the demodulator means 5 demodulates the regenerated-modulated signals SHI (t) and SHQ (t) based on the oscillated signals Px(t) and Py(t), thereby producing the demodulated signal Sdet.

As described above, according to the receiver 100 of the present embodiment, the regenerated carrier signals SCI (t) and SCQ (t), and the shifted signals SPI (t) and SPQ (t) are combined. This allows for converting the carrier component of the shifted signals SPI (t) and SPQ (t) possessing the component of the baseband signal f(t) to a carrier of the angular frequency $\omega s$ to produce the regenerated-modulated signals SHI (t) and SHQ (t). This allows the demodulator means 5 to demodulate the regenerated-modulated signals SHI (t) and SHQ(t) using, as a carrier, the oscillated signals Px(t) and Py(t) which have been generated at the oscillation means 6 in the receiver 100.

Furthermore, there may occur changes in the phase $\theta$ (t) of, frequency shifts, or frequency variations in the I signal SI(t) and the Q signal SQ (t). Even in this case, the carrier component of the shifted signals SPI (t) and SPQ (t) is converted to a carrier of the angular frequency $\omega o$, thereby producing the regenerated-modulated signals SHI (t) and SHQ (t) with stabilized carrier frequency. This allows the demodulator means 5 to use the oscillated signals Px(t) and Py(t) as a carrier for demodulating the regenerated-modulated signals SHI (t) and SHQ (t). This allows for eliminating the effects due to the aforementioned changes in the phase $\theta$(t), frequency shifts, and frequency variations, and producing the demodulated signal Sdet with high accuracy.

Furthermore, the receiver 100 of the present embodiment produces the regenerated-modulated signals SHI (t) and SHQ (t) and reproduces the demodulated signal Sdet without including a feedback loop system as for the conventional PLL synchronous detection. This allows for making full use of good trackability for the modulated signal Sin (t). Additionally, this also allows for eliminating the necessity for making difficult adjustments such as the adjustment of the loop bandwidth of the PLL loop system. Furthermore, the structure can be simplified as compared with that for the PLL synchronous detection.

Then, the receiver 100 of the present embodiment can make use of advantageous effects for synchronous detection of a modulated signal provided by linear modulation. For example, it is possible to perform synchronous detection of a modulated signal provided by AM modulation or AM stereo modulation.

Furthermore, the receiver 100 of the present embodiment described above may be formed in hardware such as transistor circuits or LSIs (integrated circuit device). Alternatively, a computer program which provides the same function as the hardware would do may be prepared. Then, DSPs (digital signal processor) or MPUs (microprocessor) may be operated on the computer program, thereby providing so-called software communications (software receptions) Furthermore, as with the first and the second embodiments, the receiver 100 may be formed of analog circuits or may also be formed of digital circuits.

[Fourth embodiment]

Now, with reference to Fig. 3 (b), a description will be made to a receiver according to a fourth embodiment. Note that in Fig. 3 (b), the components which are the same as or equivalent to those of Figs. 2(a) and 2(b) and Fig. 3 (a) are indicated with the same symbols.

In the receiver 100 of the present embodiment, the carrier generation means 2 and the combiner means 4 receive the I signal SI(t) and the Q signal SQ (t) produced in the orthogonal signal generation means 1. The combiner means 4 follows a predetermined algorithm using the addition theorem for the trigonometric functions to combine the first and second regenerated carrier signals SCI (t) and SCQ (t) produced in the carrier generation means 2, the I signal SI (t), and the Q signal SQ (t) to thereby produce an envelope signal E(t). Furthermore, the frequency shifter means 3 combines the envelope signal E(t), and the oscillated signals Px(t) and Py(t) from the oscillation means 6, thereby producing the first and second regenerated-modulated signals SHI (t) and SHQ (t).

That is, the carrier generation means 2 uses the trigonometric ratio R and the sign of the I signal SI(t) and the Q signal SQ (t) to produce a phase $\varphi$ (t), and then produce the regenerated carrier signals SCI (t) and SCQ (t) with the phase $\varphi$ (t) employed as a parameter. The combiner means 4 combines the I signal SI (t), the Q signal SQ (t), and the regenerated carrier signals SCI (t) and SCQ (t), thereby producing an envelope signal E(t) indicative of an envelope of a signal (or a combined component) obtained by combining the I signal and the Q signal. Then, the frequency shifter means 3 combines the envelope signal E(t) and the oscillated signals Px(t) and Py(t) of the angular frequency $\omega o$, which are supplied from the oscillation means 6 and have phases orthogonal each other. This allows for producing the first regenerated-modulated signal SHI(t) obtained by modulating the envelope signal E (t) using the oscillated signal Px(t) and the second regenerated-modulated signal SHQ (t) obtained by modulating the envelope signal E (t) using the oscillated signal Py (t). Accordingly, the frequency shifter means 3 of the present embodiment makes use of the function as a modulator for modulating the envelope signal E (t) using the carrier of the angular frequency $\omega s$.

Then, the demodulator means 5 demodulates the first and second regenerated-modulated signals SHI (t) and SHQ (t) based on the oscillated signals Px(t) and Py(t), thereby producing the demodulated signal Sdet.

As described above, according to the receiver 100 of the present embodiment, the combiner means 4 follows a predetermined algorithm using the addition theorem for the trigonometric functions to combine the I signal SI (t) having a carrier component expressed by cos (($\omega o$ - $\omega r$) t + $\theta$ (t)), the Q signal SQ (t) having a carrier component expressed by sin (($\omega o$ - $\omega r$) t + $\theta$ (t)), the regenerated carrier signal SCI(t) expressed by cos (($\omega o$ - $\omega r$) t + $\omega$ (t)), and the regenerated carrier signal SCQ (t) expressed by sin (($\omega o$ - $\omega r$) t + $\theta$ (t)). This allows for producing an envelope signal E(t) indicative of the envelope of a combined component of the I signal SI (t) and the Q signal SQ (t). Furthermore, the frequency shifter means 3 modulates the envelope signal E(t) with the oscillated signals Px(t) and Py(t) employed as a carrier of the angular frequency $\omega o$, thereby producing the regenerated-modulated signals SHI (t) and SHQ (t).

Accordingly, the carrier generation means 2, the combiner means 4, and the frequency shifter means 3 convert the carrier component of the I signal SI(t) and the Q signal SQ (t) to a carrier of a predetermined angular frequency $\omega s$. Thus, the regenerated-modulated signals SHI (t) and SHQ (t) are produced with a stabilized carrier frequency. Accordingly, the demodulator means 5 demodulates the regenerated-modulated signals SHI (t) and SHQ (t) based on the oscillated signals Px(t) and Py (t) of the angular frequency $\omega s$. This allows for eliminating the effects due to, for example, the changes in the phase $\theta$ (t), frequency shifts, and frequency variations of the I signal SI (t) and the Q signal SQ (t), and producing the demodulated signal Sdet with high accuracy.

Furthermore, the receiver 100 of the present embodiment produces the regenerated-modulated signals SHI (t) and SHQ (t) and reproduces the demodulated signal Sdet without including a feedback loop system as for the conventional PLL synchronous detection. This allows for making full use of good trackability for the modulated signal Sin (t). Additionally, this also allows for eliminating the necessity for making difficult adjustments such as the adjustment of the loop bandwidth of the PLL loop system. Furthermore, the structure can be simplified as compared with that for the PLL synchronous detection.

Then, the receiver 100 of the present embodiment can make use of advantageous effects for synchronous detection of a modulated signal provided by linear modulation. For example, it is possible to perform synchronous detection of a modulated signal provided by AM modulation or AM stereo modulation.

Furthermore, the receiver 100 of the present embodiment described above may be formed in hardware such as transistor circuits or LSIs (integrated circuit device). Alternatively, a computer program which provides the same function as the hardware would do may be prepared. Then, DSPs (digital signal processor) or MPUs (microprocessor) may be operated on the computer program, thereby providing so-called software communications (software receptions) . Furthermore, as with the first, second, and the third embodiments, the receiver 100 may be formed of analog circuits or may also be formed of digital circuits.

Note that the first to fourth embodiments described above employ the "carrier regenerator" like one that is disclosed in "Japanese Patent Application No. 2006-30991", where the carrier generation means 2 is configured as follows. That is, the carrier generation means 2 performs an inverse trigonometric operation on the trigonometric ratio R of the I signal SI(t) and the Q signal SQ (t), thereby producing the phase $\alpha$ (t). The carrier generation means 2 then makes a phase correction to the phase $\alpha$ (t) to yield a correct phase $\varphi$ (t) based on the sign of the I signal SI(t) and the Q signal SQ (t), thereby producing a regenerated carrier signal with the phase $\varphi$ (t) employed as a parameter. However, another "carrier regenerator" disclosed in the same Patent Application may also be employed.

[First example]

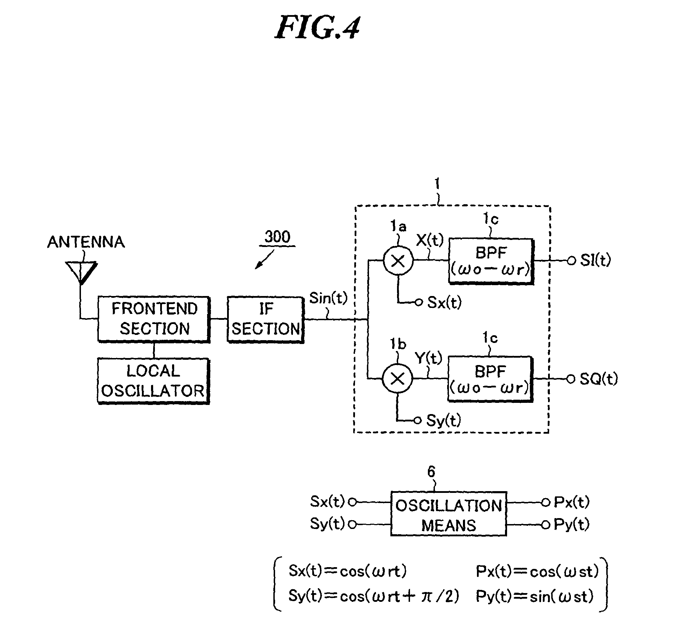

Now, with reference to Fig. 4, a description will be made to a specific example of the orthogonal signal generation means 1 described in relation to the first to fourth embodiments.

As shown in Fig. 4, the orthogonal signal generation means 1 shown in Figs. 2 (a) and 2 (b), and Figs. 3 (a) and 3 (b) is configured to include multipliers 1a and 1b for receiving the modulated signal Sin(t) produced in a receiver tuner 300, and band-pass filters 1c and 1d.

That is, an antenna provided in the receiver tuner 300 receives incoming radio waves, so that a frontend section mixes the received signal and a local signal from a local oscillator for frequency conversion, thereby producing an intermediate frequency signal. An IF section extracts and amplifies a desired signal component of a predetermined frequency band from the intermediate frequency signal to thereby produce the intermediate frequency signal (the IF signal) as the modulated signal Sin (t), which is in turn supplied to the multipliers 1a and 1b.

The multipliers 1a and 1b multiply the modulated signal Sin (t) by oscillated signals Sx(t) and Sy(t) of an angular frequency $\omega r$, which are supplied from the oscillation means 6 and have phases orthogonal to each other, thereby producing mixed signals X (t) and Y (t) expressed by Equations (1b) and (1c) above.

The band-pass filters 1c and 1d are set to a center angular frequency ($\omega o - \omega r$) and thus have a predetermined passband that is tuned to the frequency band of the modulated signal Sin (t). As such, the band-pass filter 1c extracts, as the I signal SI(t), a sideband wave component of the mixed signal X(t) shifted toward the angular frequency ($\omega o - \omega r$. On the other hand, the band-pass filter 1d extracts, as the Q signal SQ (t), a sideband wave component of the mixed signal Y (t) shifted toward the angular frequency ($\omega o - \omega r$).

As such, the orthogonal signal generation means 1 of this example produces, from the modulated signal Sin (t), the I signals SI(t) and SQ (t) having phases orthogonal to each other.

Note that the angular frequency $\omega r$ of the oscillated signals Sx (t) and Sy (t) may be independent of the carrier angular frequency $\omega o$ of the carrier g(t) of the modulated signal Sin(t), and thus can be determined as appropriate. Furthermore, setting the passband of the band-pass filters 1c and 1d as the center angular frequency ($\omega o + \omega r$) makes it possible to extract as the I signal SI (t) a signal component of the mixed signal X(t) shifted toward the angular frequency ($\omega o + \omega r$). This also allows for extracting as the Q signal SQ (t) a signal component of the mixed signal Y(t) shifted toward the angular frequency ($\omega o + \omega r$).

[Second example]

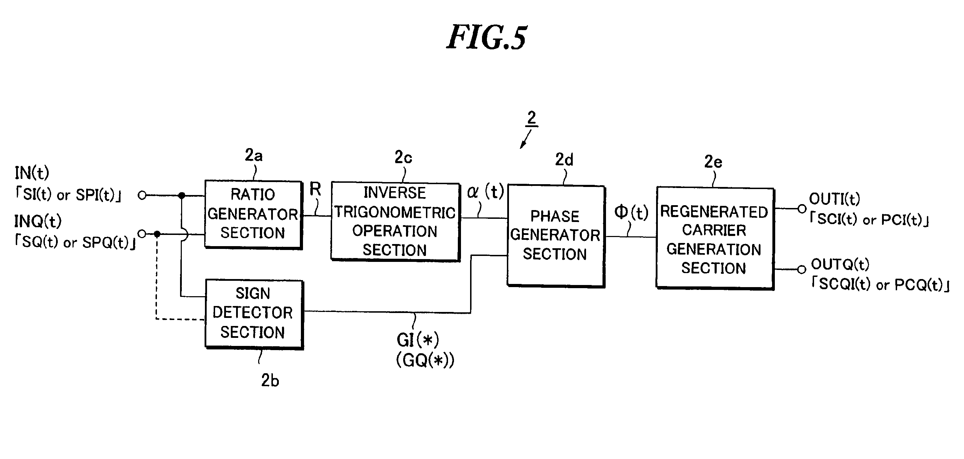

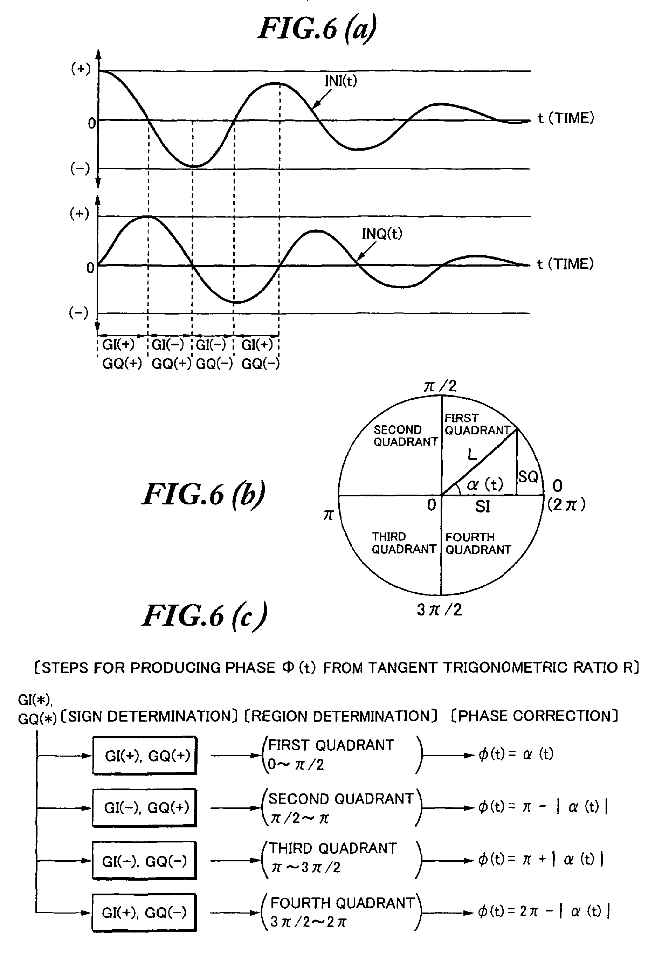

Now, with reference to Figs. 5 and 6, a description will be made to a specific example of the carrier generation means 2 described in relation to the first to fourth embodiments.

In Fig. 5, the carrier generation means 2 of this example is configured to include a ratio generator section 2a, a sign detector section 2b, an inverse trigonometric operation section 2c, a phase generator section 2d, and a regenerated carrier generation section 2e.

Here, the carrier generation means 2 of this example may be applied to the modulated signal regeneration device 200 shown in Fig. 2 (a) and Figs. 3 (a) and (b). In this case, the I signal SI (t) and the Q signal SQ (t) are supplied to the ratio generator section 2a, delivering the regenerated carrier signals 5CI (t) and SCQ (t) from the regenerated carrier generation section 2e.

Furthermore, the carrier generation means 2 of this example may be applied to the modulated signal regeneration device 200 shown in Fig. 2(b). In this case, the shifted signals SPI(t) and SPQ (t) produced in the frequency shifter means 3 are supplied to the ratio generator section 2a, delivering the regenerated carrier signals PCI(t) and PCQ (t) from the regenerated carrier generation section 2e.

In this context, for convenience of explanation, the I signal SI (t) or the shifted signal SPI (t) supplied to the ratio generator section 2a is defined as a first input signal INI(t), and the Q signal SQ (t) or the shifted signal SPQ (t) is defined as a second input signal INQ(t). Additionally, the regenerated carrier signal SCI (t) or signal PCI (t) delivered from the regenerated carrier generation section 2e is defined as a first output signal OUTI (t), and the regenerated carrier signal SCQ (t) or signal PCQ (t) is defined as a second output signal OUTQ (t).

The ratio generator section 2a produces a trigonometric ratio R based on the instantaneous amplitude of the first and second input signals INI(t) and INQ (t). That is, the following trigonometric ratios R are produced: (INQ(t)/INI (t)) as a tangent trigonometric ratio R, and $(INQ (t)/(INI (t)^2 + INQ (t)^2)^{1/2})$ as a sine trigonometric ratio R. In the same manner, also produced are secant, cotangent, cosine, and cosecant trigonometric ratios R. However, any one of the trigonometric ratios R is to be produced, for example, depending on the design specifications.

The sign detector section 2b detects the polarity of each of the first and second input signals INI (t) and INQ (t) to produce sign signals GI (*) and GQ (*) indicative of the polarity detected.

That is, the I signal SI(t) and the Q signal SQ (t) shown by way of example in Fig. 6 (a) may be supplied as the first and second input signals INI (t) and INQ (t). In this case, the sign signal GI (*) is produced which is expressed by GI(+) when the I signal SI(t) has a plus polarity and by GI (-) when it has a minus polarity. The sign signal GQ (*) is also produced which is expressed by GQ (+) when the Q signal SQ (t) has a plus polarity and by GQ (-) when it has a minus polarity.

The inverse trigonometric operation section 2c performs an inverse trigonometric operation on a trigonometric ratio R, thereby producing a phase $\alpha$ (t) for the trigonometric ratio R. That is, the inverse trigonometric operation section 2c is configured corresponding to the trigonometric ratio R produced in the ratio generator section 2a. Thus, the phase $\alpha$ (t) is produced by performing the inverse tangent operation (arctan (R)) for the "tangent" trigonometric ratio R, the inverse sine operation (arcsin (R)) for the "sine" trigonometric ratio R, the inverse secant operation (arcsec (R)) for the "secant" trigonometric ratio R, the inverse cotangent operation (arccot (R)) for the "cotangent" trigonometric ratio R, the inverse cosine operation (arccos (R)) for the "cosine" trigonometric ratio R, and the inverse cosecant operation (arccosec (R)) for the "cosecant" trigonometric ratio R.

The phase generator section 2d determines the sign of each polarity of input signals INI (t) and INQ (t) in accordance with the sign signals GI (*) and GQ (*) , and based on the determination result, makes a phase correction to the phase $\alpha$ (t) to yield a correct phase $\varphi$ (t).

That is, the phase $\alpha$ (t) is determined for the input signals INI (t) and INQ (t) by the inverse trigonometric operation being performed on the trigonometric ratio R. However, as illustrated by way of example in Fig. 6(a), this is not enough to determine the quadrant to which the phase $\alpha$ (t) belongs; the first quadrant (0 to $\pi/2$) within the phase range (0 to $2\pi$), the second quadrant ($\pi/2$ to n), the third quadrant ($\pi$ to $3\pi/2$), or the fourth quadrant ($3\pi/2$ to $2\pi$). In this context, the phase generator section 2d follows an algorithm utilizing the signs GI (*) and GQ(*) and the property of the inverse trigonometric functions to determine the quadrant to which the phase $\alpha$ (t) belongs. Based on the determination result, a phase correction is made to the phase $\alpha$ (t), thereby producing a correct phase $\varphi$ (t) that belongs to the quadrant determined.

To facilitate the understanding of the function of the phase generator section 2d, a description will be made, with reference to Figs. 6 (b) and (c), to a step of correcting the phase $\alpha$ (t) obtained by performing the inverse tangent operation (arctan (R)) on the aforementioned "tangent" trigonometric ratio R in order to yield a correct phase $\varphi$ (t).

In such a case, the phase generator section 2d determines the sign signals GI(*) and GQ (*) and then based on the determination result, makes a region determination on the quadrant to which the phase $\alpha$ (t) is to belong according to the property of the inverse trigonometric function (or the property of the inverse tangent function). That is, it is determined from the property of the inverse tangent function that the phase $\alpha$ (t) belongs to the first quadrant when both the sign signals GI (*) and GQ (*) are plus GI (+) and GQ (+), the phase $\alpha$ (t) belongs to the second quadrant when the signals are minus GI(-) and plus GQ (+), the phase $\alpha$ (t) belongs to the third quadrant when both the signals are minus GI(-) and GQ(-), and the phase $\alpha$ (t) belongs to the fourth quadrant when the signals are plus GI(+) and minus GQ (-).

Then, a phase correction is made based on the property of the inverse tangent function. That is, when the phase $\alpha$ (t) is determined to belong to the first quadrant, the phase $\alpha$ (t) is defined as the correct phase $\varphi$ (t) , and when the phase $\alpha$ (t) is determined to belong to the second quadrant, a phase ($\pi$ - |$\alpha$ (t) |) obtained by subtracting the absolute phase value |$\alpha$ (t) | from phase $\pi$ is defined as the correct phase $\varphi$ (t) . Furthermore, when the phase $\alpha$ (t) is determined to belong to the third quadrant, a phase ($\pi$ + | $\alpha$ (t) |) obtained by adding phase $\pi$ to the absolute phase value | a (t) | is defined as the correct phase $\varphi$ (t), and when the phase $\alpha$ (t) is determined to belong to the fourth quadrant, a phase ($2\pi$ - | $\alpha$ (t) | obtained by subtracting the absolute phase value |$\alpha$(t) | from phase $2\pi$ is defined as the correct phase $\varphi$ (t) .

Note that the same procedure can be followed to produce a correct phase $\varphi$ (t) from any one of the following trigonometric ratios R; "sine", "secant", "cotangent", "cosine", and "cosecant". That is, the sign and region determinations are made in accordance with the property of each inverse trigonometric function, and then based on the determination results, a phase correction is carried out, thereby producing a correct phase $\varphi$ (t).

Again in Fig. 5, based on the phase $\varphi$ (t) produced, the regenerated carrier generation section 2e produces the first output signal OUTI(t) corresponding to the first input signal INI(t) and the second output signal OUTQ (t) corresponding to the second input signal INQ (t). That is, the phase $\varphi$ (t) is applied to the cosine function to match the carrier component of the first input signal INI(t), thereby producing the first output signal OUTI (t) or a regenerated carrier signal. The phase $\varphi$(t) is also applied to the sine function to match the carrier component of the second input signal INQ (t), thereby producing the second output signal OUTQ (t) or a regenerated carrier signal.

As described above, the carrier generation means 2 of this example may be applied to the modulated signal regeneration device 200 shown in Fig. 2(a) and Figs. 3(a) and (b). In this case, the phase $\varphi$ (t) is produced based on the trigonometric ratio R and the signs GI (*) and GQ (*) of the I signal SI (t) and the Q signal SQ(t). Then, with the phase $\varphi$ (t) employed as a parameter, it is possible to produce the regenerated carrier signals SCI (t) and SCQ (t) which have phases orthogonal to each other.

Furthermore, the carrier generation means 2 may also be applied to the modulated signal regeneration device 200 shown in Fig. 2 (b). In this case, the phase $\varphi$ (t) is produced based on the trigonometric ratio R and the signs GI (*) and GQ (*) of the shifted signals SPI (t) and SPQ (t) produced in the frequency shifter means 3. Then, with the phase $\varphi$ (t) employed as a parameter, it is possible to produce the regenerated carrier signals PCI (t) and PCQ (t) which have phases orthogonal to each other.

Furthermore, the first and second output signals OUTI (t) and OUTQ (t) corresponding to the carrier component of the first and second input signals INI (t) and INQ (t) can be directly produced without the necessity of a PLL loop as for the PLL synchronous detection. It is thus possible to make full use of good trackability for the modulated signal Sin (t) and further simplify the structure.

Note that the carrier generation means 2 of this example described above is to make a phase correction to the phase $\alpha$ (t) obtained by an inverse trigonometric operation based on the signs GI (*) and GQ (*) of both the input signals INI (t) and INQ (t) to produce the correct phase $\varphi$ (t). However, in some cases, only either the sign GI (*) or GQ (*) can be used to determine the quadrant (or the region) to which the phase $\alpha$ (t) belongs based on the property of the inverse trigonometric function. It is thus not always necessary to make a phase correction based on both the signs GI (*) and GQ (*). What is essential is to use at least one of the signs GI (*) and GQ (*) in order to determine the quadrant to which the phase $\alpha$ (t) computed from a trigonometric ratio R belongs based on the property of the inverse trigonometric function.

[Third example]

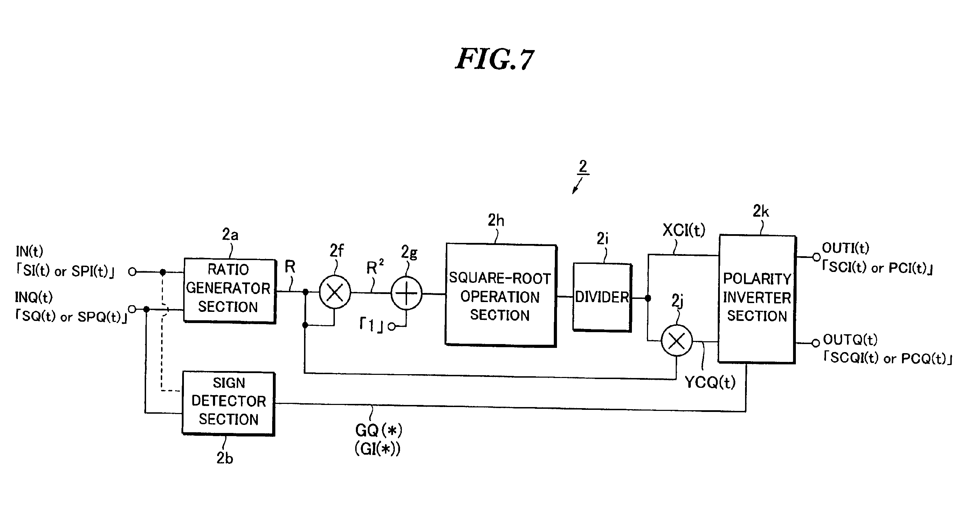

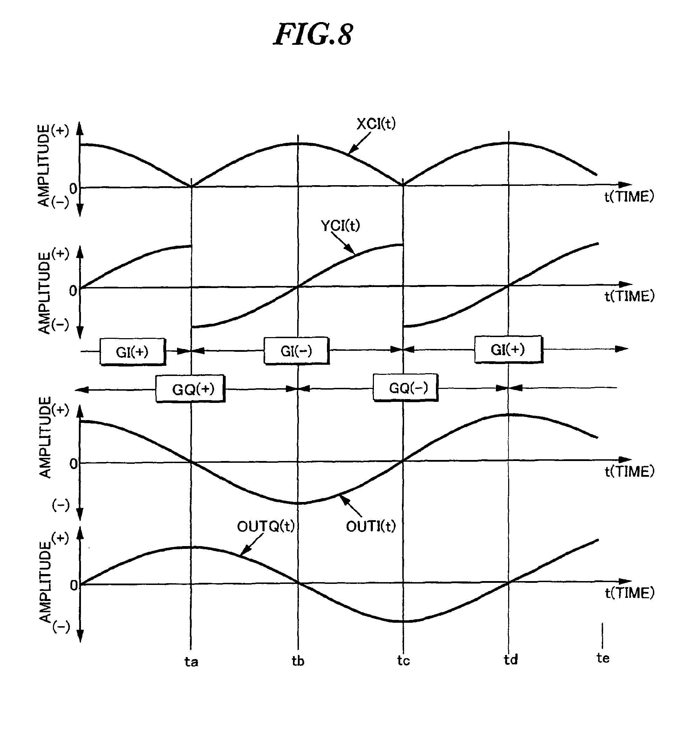

Now, with reference to Figs. 7 and 8, a description will be made to another example of the carrier generation means 2 described in relation to the first to fourth embodiments. Fig. 7 is a block diagram illustrating the configuration of the carrier generation means 2 of this example. Fig. 8 is an explanatory view illustrating the function of the carrier generation means 2.

In Fig. 7, the carrier generation means 2 is configured to include the ratio generator section 2a, the sign detector section 2b, multipliers 2f and 2j, an adder 2g, a square-root operation section 2h, a divider 2i, and a polarity inverter section 2k.

First, a description will be made to the configuration of the carrier generation means 2 of this example in contrast to that of the second example. In the carrier generation means 2 of the second example (see Fig. 5), an inverse trigonometric operation is performed to find the phase $\alpha$ (t) for a trigonometric ratio R. Then, a phase correction is made to the phase $\alpha$ (t) based on the sign signals GI(*) and GQ (*) to produce the correct phase $\varphi$ (t), and thereafter, a regenerated carrier signal is produced.

In contrast to this, the carrier generation means 2 of this example shown in Fig. 7 utilizes the relational expression given by Equations (8a) and (8b) below which are obtained from the properties of the trigonometric ratio R and the trigonometric function by differentiating an inverse trigonometric function using the differentiation of the inverse trigonometric function. This allows for directly producing a regenerated carrier signal based on the ratio R and the sign.

Note that in the same manner as in the second example, for convenience of explanation, a description will be made assuming that the first and second input signals INI (t) and INQ (t) are received, and the first and second output signals OUTI(t) and OUTQ (t) are produced for delivery as a regenerated carrier signal.

In Fig. 7, the ratio generator section 2a produces the ratio R (INQ (t) /INI (t)) of the first and second input signals INI (t) and INQ (t), the multiplier 2f computes the squared value ($R^2$) of the ratio R, and then the adder 2g adds 1 to the squared value ($R^2$), thereby calculating a value ($1 + R^2$) shown in Equation (8a) below. Furthermore, the square-root operation section 2h computes the square root value SQRT ($1 + R^2$) of the value ($1 + R^2$), and then the divider section 2i computes the reciprocal of the square root value SQRT ($1 + R^2$). This allows for calculating a value ($1/ (1 + R^2)^{1/2}$) shown in Equation (8a) below for supply to the multiplier 2j and the polarity inverter section 2k as a pre-signal XCI (t) . Furthermore, the multiplier 2j multiplies the value ($1/ (1 + R^2)^{1/2}$ by the ratio R from the ratio generator section 2a, thereby calculating a value ($R/ (1 + R^2)^{1/2}$) shown in Equation (8b) below for supply to the polarity inverter section 2k as a pre-signal YCQ(t).

Here, when the pre-signals XCI (t) and YCQ (t) are produced through the arithmetic operation based on the instantaneous amplitude of the first and second input signals INI (t) and INQ (t), the value computed in the computing process is inverted to plus or minus. Accordingly, as illustrated by way of example in Fig. 8, the pre-signal XCI (t) and YCQ (t) are produced but not as a correct regenerated carrier signal which is in sync with the carrier component of the first and second input signals INI (t) and INQ (t).

In this context, based on at least either the sign signal GQ (*) or GI (*), the polarity inverter section 2k determines the period during which the polarity of the pre-signals XCI (t) and YCQ (t) is inverted. Then, based on the result of the determination, the polarity of the pre-signals XCI (t) and YCQ (t) is inverted. That is, in the case of Fig. 8, when the sign signal GI (*) is minus GI (-), the polarity of the pre-signals XCI (t) and YCQ (t) is inverted. As shown in Fig. 8, this allows for producing the output signals OUTI (t) and OUTQ (t) which serve as a correct regenerated carrier signal.

[Equation 8]

$$XCI(t) = \cos\phi(t) = 1 / \{1 + \tan^2\phi(t)\}^{1/2} = 1 / (1 + R^2)^{1/2} \qquad \cdots (8a)$$

$$YCQ(t) = \sin\phi(t) = \cos\phi(t) \times \tan^2\phi(t) = R / (1 + R^2)^{1/2} \qquad \cdots (8b)$$

As described above, the carrier generation means 2 of this example performs a predetermined arithmetic operation using the trigonometric ratio R of the input signals INI (t) and INQ (t) and the property of trigonometric functions. This allows for producing the pre-signals XCI (t) and YCQ(t) having phases orthogonal to each other and then based on the signs GI (*) and GQ (*), performing the polarity inversion processing. It is thus possible to quickly produce the output signals OUTI (t) and OUTQ (t), which serve as a regenerated carrier signal.

Furthermore, unlike the conventional PLL synchronous detection, this example can also directly produce a regenerated carrier. This allows for eliminating the necessity for making difficult adjustments such as the adjustment of the loop bandwidth of a PLL loop system. Furthermore, the structure can be simplified as compared with that for the PLL synchronous detection.

[Fourth example]

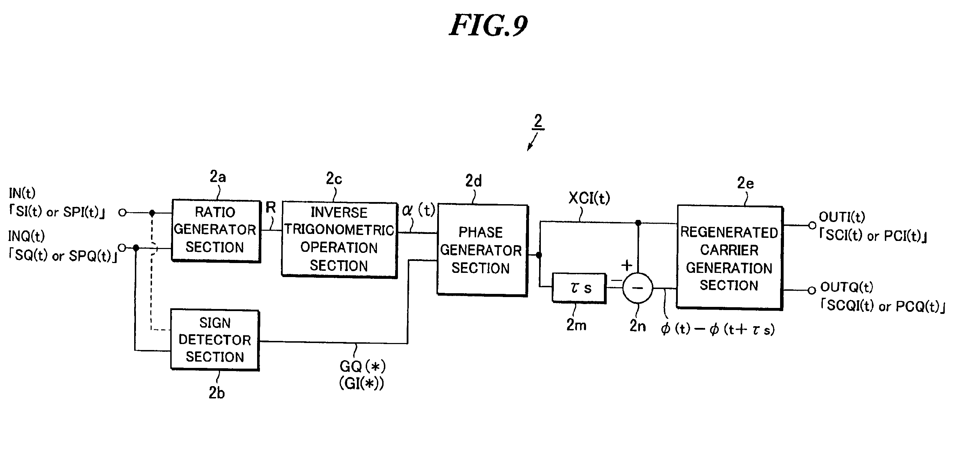

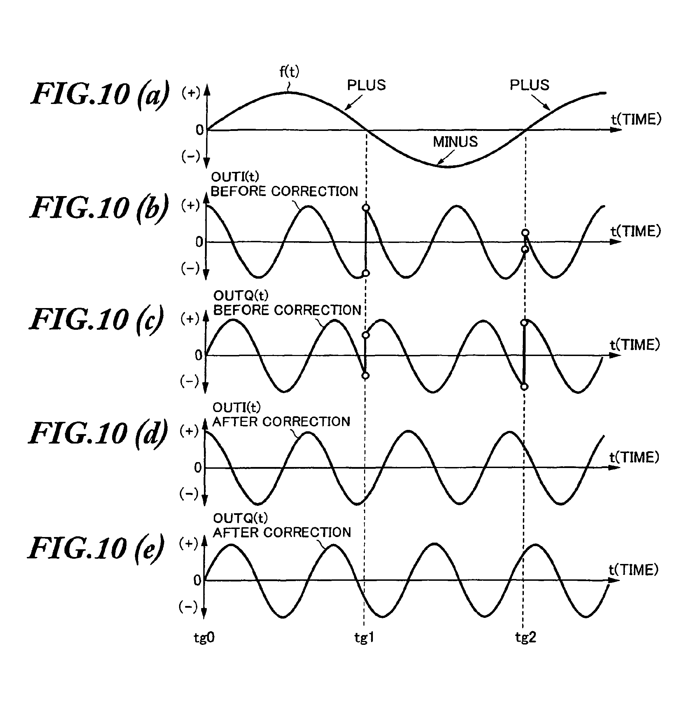

Now, with reference to Figs. 9 and 10, a description will be made to an example corresponding to still another modified example of the carrier generation means 2 described in relation to the first to fourth embodiments.

First, a description will be made to the difference in functions between the carrier generation means 2 of this example and the carrier generation means 2 of the second example shown in Fig. 5. When the baseband signal f (t) having a normally plus polarity and modulated with the carrier g(t) is transmitted from a transmitting station, the carrier generation means 2 of the second example can produce correct output signals OUTI (t) and OUTQ (t) based on the input signals INI(t) and INQ(t). However, as illustrated by way of example in Fig. 10(a), when the baseband signal f(t) varies between plus and minus polarities, correct output signals OUTI(t) and OUTQ (t) may not be created as illustrated in Figs. 10(b) and (c).

The carrier generation means 2 of this example includes the function of producing correct output signals OUTI (t) and OUTQ (t) even when the modulated signal regeneration device 200 receives the modulated signal Sin(t) obtained by modulating the baseband signal f(t) which varies between plus and minus polarities.

As shown in Fig. 9, the carrier generation means 2 of this example is configured as the carrier generation means 2 shown in Fig. 5 which is further provided with a delay circuit 2m and a subtractor2n. The phase φ (t) produced in the phase generator section 2d and the phase difference (φ(t) - φ (t + r s)) produced in the delay circuit 2m and the subtractor 2n are supplied to the regenerated carrier generation section 2e.

Here, the delay circuit 2m is set at a delay time is corresponding to the reciprocal (1/fs) of frequency fs which satisfies the sampling theorem for the input signals INI(t) and INQ (t). Thus, the delay circuit 2m delays the phase φ (t) produced in the phase generator section 2d, and then supplies the delayed phase φ (t + rs) to the subtractor 2n.

The regenerated carrier generation section 2e of this example compares the absolute value | φ (t) - φ (t + rs) of the phase difference (φ (t) - φ (t + τs)) with a predetermined threshold value THDφ. As shown in Figs. 10 (b) and (c), when the absolute value |φ (t) - φ (t + rs) | is detected to exceed the threshold value THDφ, it is determined that the polarity would be inverted upon creation of the output signals OUTI(t) and OUTQ (t). Then, during the period ("inverted period") from the determined point in time tg1 to a point in time tg2 at which the absolute value |φ (t) - φ(t + rs)| is subsequently detected to exceed the threshold value THDφ, a correction is made to yield a phase (φ(t) + φ) by adding phase n to the phase φ (t). The corrected phase (φ (t) + π) is applied to the cosine function to thereby produce the output signal OUTI (t), while the phase (φ (t) + π) is applied to the sine function to thereby produce the output signal OUTQ (t).

Here, the regenerated carrier creation section 2e makes a determination on the aforementioned polarity inversion at points in time tg0, tg1, tg2, ...; however, corrects the phase φ (t) to yield the phase (φ (t) +π) at non-consecutive discrete time intervals.

That is, during the period from the point in time tg0 to tg1 ("non-inverted period"), the output signals OUTI (t) and OUTQ (t) are produced based on the phase π (t). Then, during the next period from the point in time tg1 to tg2, the output signals OUTI (t) and OUTQ (t) are produced based on the phase (φ (t) + π), and during the next period from the point in time tg2 to tg3, the output signals OUTI (t) and OUTQ (t) are produced based on the phase φ (t). Similarly from then onwards, the phase (φ (t) + π) corrected at non-consecutive discrete time intervals is applied to the cosine function and the sine function to produce the output signals OUTI(t) and OUTQ(t).

As such, the regenerated carrier generation section 2e corrects the phase φ (t) at non-consecutive discrete time intervals to yield the phase (φ (t) + π), thereby producing the correct output signals OUTI (t) and OUTQ (t) as shown in Figs. 10(d) and (e).

As described above, the carrier generation means 2 of this example can produce the correct output signals OUTI (t) and OUTQ (t) even when the baseband signal f(t) of the modulated signal Sin(t) varies between plus and minus polarities.

Furthermore, unlike the conventional PLL synchronous detection, this example can also directly produce a regenerated carrier. This also allows for eliminating the necessity for making difficult adjustments such as the adjustment of the loop bandwidth of the PLL loop system. Furthermore, the structure can be simplified as compared with that for the PLL synchronous detection.

[Fifth example]

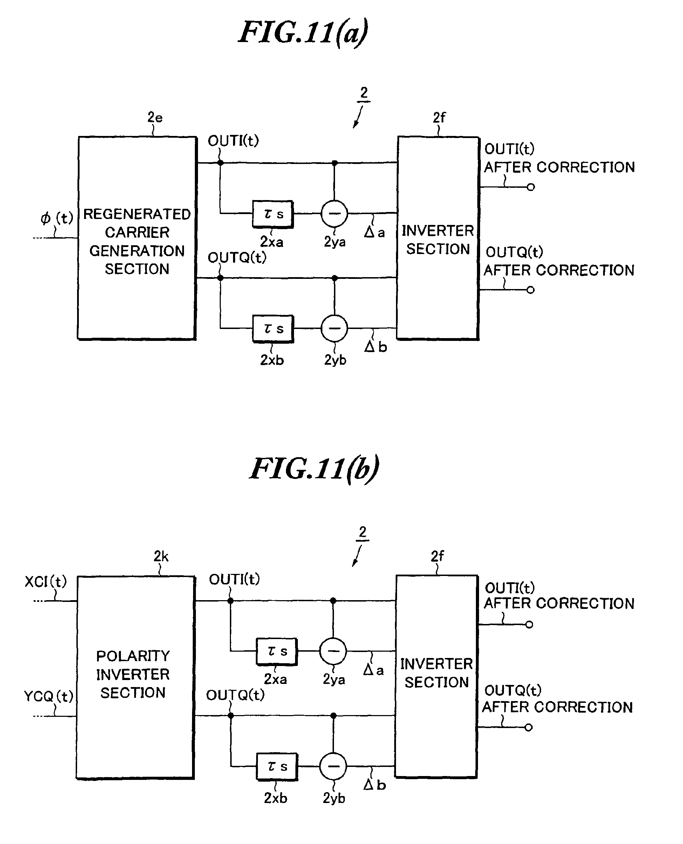

Now, with reference to Fig. 11, a description will be made to still another example of the carrier generation means 2 described in relation to the first to fourth embodiments.

The carrier generation means 2 of this example is also configured to produce the correct output signals OUTI (t) and OUTQ (t) using a predetermined correction function when the baseband signal f(t) of the modulated signal Sin (t) varies between plus and minus polarities.

Note that Fig. 11(a) illustrates an example in which means for making full use of the aforementioned correction capability is provided downstream of the regenerated carrier generation section 2e included in the carrier generation means 2 shown in Fig. 5. Fig. 11(b) illustrates an example in which means for making full use of the aforementioned correction function is provided downstream of the polarity inverter section 2k included in the carrier generation means 2 shown in Fig. 7. A description will now be made to these two examples one by one.

[Example of Fig. 11(a)]

The carrier generation means 2 shown in Fig. 11 (a) includes delay sections 2xa and 2xb for delaying, by a predetermined delay time τs, the respective output signals OUTI (t) and OUTQ (t) supplied after having been produced in the regenerated carrier generation section 2e shown in Fig. 5. Further included are difference operational units 2ya and 2yb for producing differences Δa and Δb between the delayed signals and the output signals OUTI (t) and OUTQ (t), respectively. Also included is an inverter section 2f for receiving the output signals OUTI (t) and OUTQ (t) and the differences Δa and Δb, so that the corrected signals produced in the inverter section 2f are delivered as the output signals OUTI(t) and OUTQ (t) . Note that as described in relation to the fourth example, the delay time τ is so set as to satisfy the sampling theorem.

The inverter section 2f compares each of the absolute values |Δa| and |Δb| of the differences Δa and Δb with a predetermined threshold value THDab. Upon detection of the threshold value THDab being exceeded, it is determined that the polarity of each of the output signals OUTI(t) and OUTQ (t) supplied from the regenerated carrier generation section 2e has been inverted. Then, during the period from the point in time of determining the polarity inversion to the point in time of determining the next polarity inversion, the polarity of the output signals OUTI (t) and OUTQ (t) supplied is inverted. During the period from then to the point in time of determining the next polarity inversion, the polarity is not inverted. From then onwards, the inversion processing is performed at non-consecutive discrete time intervals.

As such, the inverter section 2f determines that the absolute values |Δa| and |Δb| are greater than the threshold value THDab, and performs the inversion processing at non-consecutive discrete time intervals on the output signals OUTI(t) and OUTQ (t) supplied. In the same manner as illustrated in Figs. 10 (d) and (e), the output signals corrected to have a correct waveform (the corrected output signals) OUTI (t) and OUTQ (t) are produced for output.

[Example of Fig. 11(b)]

The carrier generation means 2 shown in Fig. 11 (b) includes delay sections 2xa and 2xb for delaying, by a predetermined delay time τs (which satisfies the sampling theorem), the respective output signals OUTI(t) and OUTQ (t) supplied after having been produced in the polarity inverter section 2k shown in Fig. 7. Further included are difference operational units 2ya and 2yb for producing differences Δa and Δb between the delayed signals and the output signals OUTI (t) and OUTQ (t), respectively. Also included is an inverter section 2f for receiving the output signals OUTI (t) and OUTQ (t) and the differences Δa and Δb, so that the corrected signals produced in the inverter section 2f are delivered as the output signals OUTI (t) and OUTQ (t).

As with the example of Fig. 11(a), the inverter section 2f of this example also compares each of the absolute values |Δa| and |Δb| of the differences Δa and Δb with a predetermined threshold value THDab. Upon detection of the threshold value THDab being exceeded, it is determined that the polarity of each of the output signals OUTI (t) and OUTQ (t) supplied from the regenerated carrier generation section 2e has been inverted. Then, during the period from the point in time of determining the polarity inversion to the point in time of determining the next polarity inversion, the polarity of the output signals OUTI (t) and OUTQ (t) supplied is inverted. During the period from then to the point in time of determining the next polarity inversion, the polarity is not inverted. From then onwards, the inversion processing is performed at non-consecutive discrete time intervals.

As such, the inverter section 2f determines that the absolute values Δal and |Δb| are greater than the threshold value THDab, and performs the inversion processing at non-consecutive discrete time intervals on the output signals OUTI (t) and OUTQ (t) supplied. In the same manner as illustrated in Figs. 10 (d) and (e), the output signals corrected to have a correct waveform (the corrected output signals) OUTI (t) and OUTQ (t) are produced for output.

As such, the carrier generation means 2 shown in Figs. 11 (a) and (b) can produce more correct first and second the output signals OUTI (t) and OUTQ (t) based on first and second pre-signals POUTI (t) and POUTQ (t) produced in a first polarity inverter section 2h. This is possible even when the amplitude of the baseband signal f(t) varies between plus and minus polarities.

Furthermore, the carrier generation means 2 of this example can also directly produce the first and second output signals OUTI (t) and OUTQ (t) from the first and second input signals INI (t) and INQ(t) without the necessity of a PLL loop as for the PLL synchronous detection. It is thus possible to make full use of good trackability for the modulated signal Sin (t) and further simplify the structure.

[Sixth example]

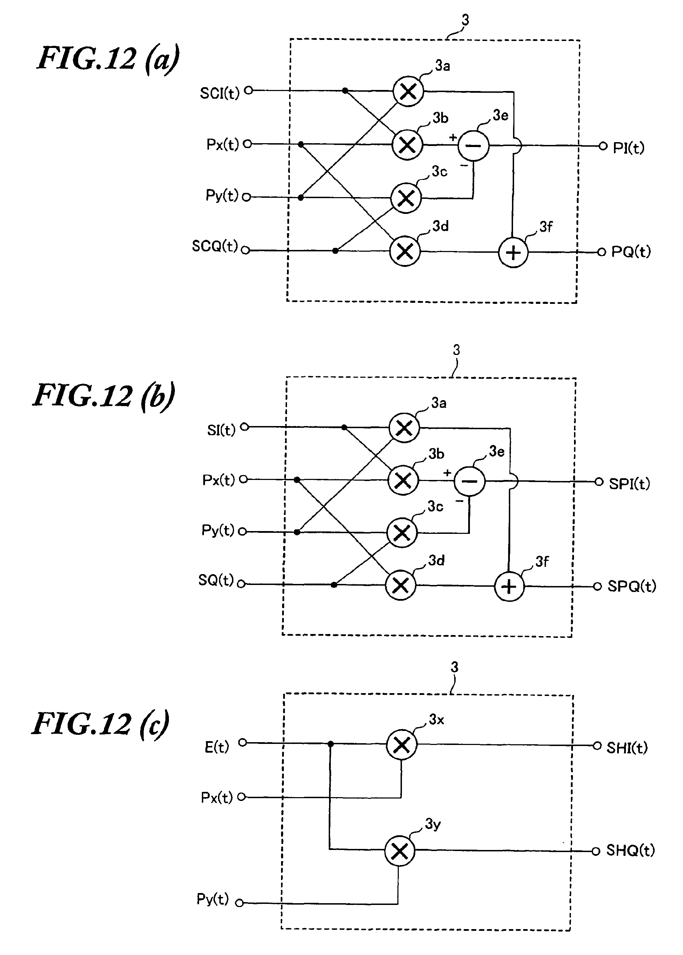

Now, with reference to Fig. 12, a description will be made to an example of the frequency shifter means 3 described in relation to the first to fourth embodiments.

Note that Fig. 12 (a) is a block diagram illustrating the configuration of the frequency shifter means 3 applied to the modulated signal regeneration device 200 shown in Fig. 2 (a). Fig. 12(b) is a block diagram illustrating the configuration of the frequency shifter means 3 applied to the modulated signal regeneration device 200 shown in Figs. 2 (b) and 3 (a). Fig. 12 (c) is a block diagram illustrating the configuration of the frequency shifter means 3 applied to the modulated signal regeneration device 200 shown in Fig. 3(b).

The frequency shifter means 3 of Fig. 12 (a) is configured to include multipliers 3a to 3d, a subtractor 3e, and an adder 3f. Following the addition theorem for the trigonometric functions, the frequency shifter means 3 combines the regenerated carrier signals SCI (t) and SCQ(t), produced in the carrier generation means 2 and having phases orthogonal to each other, and the oscillated signals Px (t) and Py(t) of the angular frequency ωs, delivered from the oscillation means 6 and having phases orthogonal to each other. This allows for producing the shifted signals PI (t) and PQ (t) which are shifted by the angular frequency ωs relative to the regenerated carrier signals SCI (t) and SCQ (t).

That is, the multiplier 3a multiplies the regenerated carrier signal SCI (t) by the oscillated signal Py(t), while the multiplier 3bmultiplies the regenerated carrier signal SCI (t) by the oscillated signal Px (t). The multiplier 3c multiplies the regenerated carrier signal SCQ (t) by the oscillated signal Py(t), while the multiplier 3dmultiplies the regenerated carrier signal SCQ (t) by the oscillated signal Px (t) .

Then, the adder 3f adds the output of the multiplier 3a to the output of the multiplier 3d, thereby producing the shifted signal PQ (t) obtained by shifting the regenerated carrier signal SCQ (t) by the angular frequency ωs. The subtractor 3e subtracts the output of the multiplier 3c from the output of the multiplier 3b, thereby producing the shifted signal PI(t) obtained by shifting the regenerated carrier signal SCI (t) by the angular frequency ωs.

That is, the frequency shifter means 3 of Fig. 12 (a) follows the addition theorem expressed by Equations (9a) and (9b) below to perform the combining operation, thereby producing the signals PI (t) and PQ (t) obtained by shifting the regenerated carrier signals SCI (t) and SCQ (t) by the angular frequency ωs.

[Equation 9]

$$PI(t) = SCI(t) \times Px(t) - SCQ(t) \times Py(t)$$
$$= cos((\omega_o - \omega_r + \omega_s) \ t + \theta(t)) \quad \cdots (9a)$$

$$PQ(t) = SCI(t) \times Py(t) + SCQ(t) \times Px(t)$$
$$= sin((\omega_o - \omega_r + \omega_s) \ t + \theta(t)) \quad \cdots (9b)$$

The frequency shifter means 3 of Fig. 12(b) is configured in the same manner as in Fig. 12 (a). However, the frequency shifter means 3 of Fig. 12 (a) is supplied with the regenerated carrier signals SCI(t) and SCQ (t), whereas the frequency shifter means 3 of Fig. 12(b) is supplied with the I signal SI(t) and the Q signal SQ (t).

Then, the multiplier 3a multiplies the I signal SI (t) by the oscillated signal Py (t) ; the multiplier 3b multiplies the I signal SI (t) by the oscillated signal Px (t) ; the multiplier 3c multiplies the Q signal SQ (t) by the oscillated signal Py (t) ; and the multiplier 3d multiplies the Q signal SQ (t) by the oscillated signal Px(t). The adder 3f adds the output of the multiplier 3a to the output of the multiplier 3d, thereby producing the shifted signal SPQ (t) obtained by shifting the Q signal SQ (t) by the angular frequency $\omega$s. The subtractor 3e subtracts the output of the multiplier 3c from the output of the multiplier 3b, thereby producing the shifted signal SPI (t) obtained by shifting the I signal SI (t) by the angular frequency $\omega$s.

That is, the frequency shifter means 3 of Fig. 12 (b) follows the addition theorem expressed by Equations (10a) and (10b) below to perform the combining operation, thereby producing the shifted signals SPI(t) and SPQ(t) obtained by shifting the I signal SI (t) and the Q signal SQ(t) by the angular frequency $\omega$s.

[Equation 10]

$$SPI(t) = SI(t) \times Px(t) - SQ(t) \times Py(t)$$
$$= 0.5 \times f(t) \times cos((\omega_o - \omega_r + \omega_s) t + \theta(t)) \quad \cdots (10a)$$

$$SPQ(t) = SI(t) \times Py(t) + SQ(t) \times Px(t)$$
$$= 0.5 \times f(t) \times sin((\omega_o - \omega_r + \omega_s) t + \theta(t)) \quad \cdots (10b)$$

Note that the frequency shifter means 3 of Figs. 12(a) and (b) described above produces the shifted signals PI(t), PQ(t), SPI(t), and SPQ(t) expressed by Equations (9a) to (10b) above when the I signal SI (t) and the Q signal SQ (t) produced in the orthogonal signal generation means 1 have a signal component on the angular frequency (wo - $\omega$r) side. The term of the angular frequency ($\omega$o - wr + $\omega$s) in Equations (9a) to (10b) above takes on ($\omega$o + $\omega$r + ws) when the I signal SI(t) and the Q signal SQ(t) have a signal component on the angular frequency (wo + $\omega$r) side.

Furthermore, the angular frequency of the oscillated signals Px (t) and Py (t) supplied from the oscillation means 6 may be a minus angular frequency (-$\omega$s). In this case, each subtractor 3e of Figs. 12 (a) and (b) is configured to subtract the output of the multiplier 3b from the output of the multiplier 3c.

Now, the frequency shifter means 3 of Fig. 12(c) includes multipliers 3x and 3y for receiving the envelope signal E (t) produced in the combiner means 4 and the oscillated signals Px (t) and Py(t) from the oscillation means 6. The multiplier 3x multiplies the envelope signal E(t) by the oscillated signal Px(t) expressed by cos ($\omega$st), thereby producing the regenerated-modulated signal SHI(t) The envelope signal E(t) is multiplied by the oscillated signal Py(t) expressed by sin ($\omega$st), thereby producing the regenerated-modulated signal SHQ(t). On the other hand, when the angular frequency of the oscillated signals Px(t) and Py(t) is a minus angular frequency (-$\omega$s), the frequency shifter means 3 is also configured in the same manner as in Fig. 12(c).

[Seventh example]

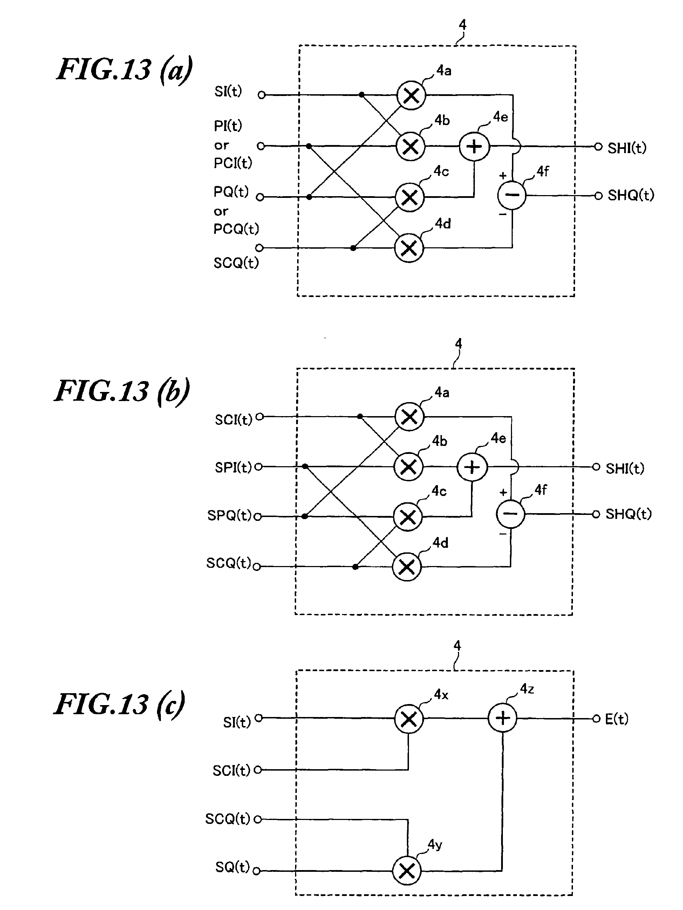

Now, with reference to Fig. 13, a description will be made to an example of the combiner means 4 described in relation to the first to fourth embodiments.

Note that Fig. 13(a) is a block diagram illustrating the configuration of the combiner means 4 applied to the modulated signal regeneration device 200 shown in Fig. 2(a) or the combiner means 4 applied to the modulated signal regeneration device 200 shown in Fig. 2(b). Fig. 13(b) is a block diagram illustrating the configuration of the combiner means 4 applied to the modulated signal regeneration device 200 shown in Fig. 3(a) . Fig. 13 (c) is a block diagram illustrating the configuration of the combiner means 4 applied to the modulated signal regeneration device 200 shown in Fig. 3(b).

The combiner means 4 of Fig. 13(a) is configured to include multipliers 4a to 4d, an adder 4e, and a subtractor 4f.

Then, the combiner means 4 may be applied to the modulated signal regeneration device 200 shown in Fig. 2(a). In this case, the multiplier 4a multiplies the I signal SI (t) by the shifted signal PQ (t) ; the multiplier 4b multiplies the I signal SI (t) by the shifted signal PI(t); the multiplier 4c multiplies the Q signal SQ(t) by the shifted signal PQ(t); and the multiplier 4d multiplies the Q signal SQ (t) by the shifted signal PI(t). The subtractor 4f subtracts the output of the multiplier 4d from the output of the multiplier 4a to thereby produce the regenerated-modulated signal SHQ(t), whereas the adder 4e adds the outputs of the multipliers 4b and 4c, thereby producing the regenerated-modulated signal SHI(t). That is, the addition theorem expressed by Equations (11a) and (11b) below is followed to perform the combining operation, thereby producing the regenerated-modulated signals SHI(t) and SHQ(t).

[Equation 11]

$$\mathbf{SHI(t)} = \mathbf{SI(t)} \times \mathbf{PI(t)} + \mathbf{SQ(t)} \times \mathbf{PQ(t)}$$
$$= 0.5 \times \mathbf{f(t)} \times \cos(\omega_s t) \qquad \cdots (11a)$$

$$\mathbf{SHQ(t)} = \mathbf{SI(t)} \times \mathbf{PQ(t)} - \mathbf{SQ(t)} \times \mathbf{PI(t)}$$
$$= 0.5 \times \mathbf{f(t)} \times \sin(\omega_s t) \qquad \cdots (11b)$$

On the other hand, the combiner means 4 of Fig. 13(a) may be applied to the modulated signal regeneration device 200 shown in Fig. 2(b). In this case, a predetermined algorithm based on the addition theorem for the trigonometric functions is followed to combine the I signal SI (t), the Q signal SQ(t), and the regenerated carrier signals PCI(t) and PCQ(t) produced in the carrier generation means 2 of Fig. 2(b). This allows for producing the regenerated-modulated signals SHI (t) and SHQ (t) expressed in (11a) and (11b) above.

Now, the combiner means 4 of Fig. 13 (b) is configured to include multipliers 4a to 4d, the adder 4e, and the subtractor 4f. The multiplier 4a multiplies the regenerated carrier signal SCI (t) by the shifted signal SPQ(t); the multiplier 4b multiplies the regenerated carrier signal SCI(t) by the shifted signal SPI(t); the multiplier 4c multiplies the regenerated carrier signal SCQ(t) by the shifted signal SPQ (t) ; and the multiplier 4d multiplies the regenerated carrier signal SCQ (t) by the shifted signal SPI(t). The subtractor 4f subtracts the output of the multiplier 4d from the output of the multiplier 4a to thereby produce the regenerated-modulated signal SHQ(t), while the adder 4e adds the outputs of the multipliers 4b and 4c, thereby producing the regenerated-modulated signal SHI(t).

That is, the frequency shifter means 4 of Fig. 13 (b) follows the addition theorem for the trigonometric functions expressed by Equations (12a) and (12b) below to perform the combining operation, thereby producing the regenerated-modulated signals SHI(t) and SHQ(t).

[Equation 12]

$$SHI(t) = SCI(t) \times SPI(t) + SCQ(t) \times SPQ(t)$$
$$= 0.5 \times f(t) \times \cos(\omega_s t) \quad \cdots (12a)$$

$$SHQ(t) = SCI(t) \times SPQ(t) - SCQ(t) \times SPI(t)$$
$$= 0.5 \times f(t) \times \sin(\omega_s t) \quad \cdots (12b)$$

Note that the combiner means 4 of Figs. 13 (a) and (b) described above produces the regenerated-modulated signals SHI(t) and SHQ(t) expressed by Equations (11a) to (12b) above when the I signal SI(t) and the Q signal SQ(t) produced in the orthogonal signal generation means 1 have a sideband wave component on the angular frequency ($\omega o$ - $\omega r$) side. The term of the angular frequency ($\omega o$ - $\omega r$ + $\omega s$) in Equations (11a) to (12b) above takes on ($\omega o$ + $\omega r$ + $\omega s$) when the I signal SI (t) and the Q signal SQ(t) have a sideband wave component on the angular frequency ($\omega o$ + $\omega r$) side.

Furthermore, the angular frequency of the oscillated signals Px (t) and Py (t) supplied from the oscillation means 6 may be a minus angular frequency (-$\omega s$). In this case, each subtractor 4f of Figs. 13 (a) and (b) is configured to subtract the output of the multiplier 4a from the output of the multiplier 4d.

Now, the combiner means 4 of Fig. 13 (c) is configured to include multipliers 4x and 4y, and an adder 4z. Then, the multiplier 4x multiplies the I signal SI(t) by the regenerated carrier signal SCI (t), and the multiplier 4y multiplies the Q signal SQ (t) by the regenerated carrier signal SCQ(t). The adder 4z adds the outputs of the multipliers 4x and 4y. This allows for producing the envelope signal E(t).

[Eighth example]

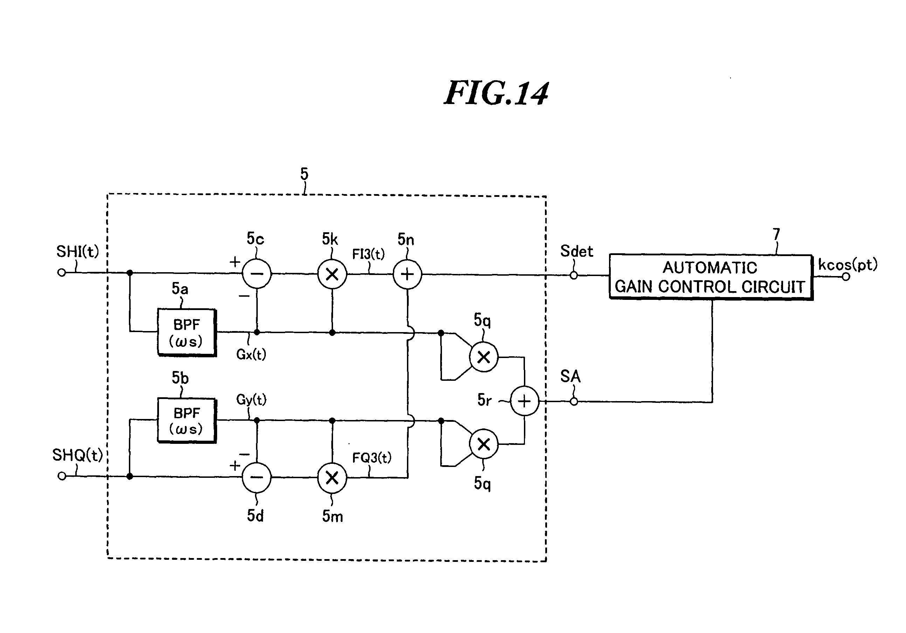

Now, with reference to Fig. 14, a description will be made to an example of the demodulator means 5 described in relation to the first to fourth embodiments.

The demodulator means 5 of this example is configured to include band-pass filters 5a and 5b, subtractors 5c and 5d, multipliers 5k, 5m, 5p, and 5q, and adders 5n and 5r. The demodulator means 5 receives the regenerated-modulated signals SHI(t) and SHQ(t), and then performs predetermined arithmetic operation to produce the demodulated signal Sdet and the gain signal SA indicative of the gain of the demodulated signal Sdet. The demodulator means 5 is also connected with an automatic gain control circuit 7.

The band-pass filters 5a and 5b are formed of a band-pass filter having a center angular frequency set at $\omega s$. The band-pass filter 5a extracts from the regenerated-modulated signal SHI (t) its carrier component Gx(t), while the band-pass filter 5b extracts from the regenerated-modulated signal SHQ(t) its carrier component Gy(t).

The subtractor 5c subtracts the carrier component Gx(t) from the regenerated-modulated signal SHI(t), and the multiplier 5k multiplies the output of the subtractor 5c by the carrier component Gx(t), thereby producing a signal FI3 (t) expressed by Equation (13a) below.

The subtractor 5d subtracts the carrier component Gy(t) from the regenerated-modulated signal SHQ(t), and the multiplier 5m multiplies the output of the subtractor 5d by the carrier component Gy(t), thereby producing a signal FQ3(t) expressed by Equation (13b) below. Then, the adder 5n adds the signals FI3 (t) and FQ3 (t) and thereby cancels the angular frequency $\omega s$ component, thus producing the demodulated signal Sdet as expressed by Equation (13c) below.

[Equation 13]

$$FI3(t) = \{SHI(t) - G_x(t)\} \times G_x(t)$$
$$= (0.5 \times A)^2 \times k \cos(pt) \times (\cos(\omega_s t))^2 \quad \cdots (13a)$$

$$FQ3(t) = \{SHQ(t) - G_y(t)\} \times G_y(t)$$
$$= (0.5 \times A)^2 \times k \cos(pt) \times (\sin(\omega_s t))^2 \quad \cdots (13b)$$

$$S\det = FI3(t) + FQ3(t)$$
$$= (0.5 \times A)^2 \times k \cos(pt) \quad \cdots (13c)$$

The multipliers 5p and 5q compute the squared value of the carrier component Gx(t) and the squared value of the carrier component Gy(t), respectively. The adder 5r adds the outputs of the multipliers 5p and 5q. This allows for producing the gain signal SA indicative of the gain of the demodulated signal Sdet as expressed by Equation (14) below.
[Equation 14]

$$SA = Gx(t) \times Px(t) + Gy(t) \times Py(t)$$
$$= (0.5 \times A)^2 \times \{(\cos(\omega_s t))^2 + (\sin(\omega_s t))^2\} = (0.5 \times A)^2 \quad \cdots (14)$$

The automatic gain control circuit 7 divides the demodulated signal Sdet by the signal SA, thereby producing for output a demodulated signal (kcos(pt)) immune to, for example, variations in electric field strength (signal strength).
As described above, the demodulator means 5 of this example can reproduce the demodulated signal Sdet from the regenerated-modulated signals SHI(t) and SHQ(t) as well as can produce a demodulated signal immune to, for example, variations in electric field strength (signal strength). It is thus possible to produce the gain signal SA for the automatic gain control circuit 7 to provide automatic gain control.
Furthermore, the regenerated-modulated signals SHI(t) and SHQ(t) have the carrier component at the angular frequency ωs with no frequency shift, frequency variation, and phase variation. It is thus possible to fix the center angular frequency of the band-pass filters 5a and 5b to the angular frequency ωs. That is, it is possible to form the band-pass filters 5a and 5b of a band-pass filter having a fixed characteristic.

[Ninth example]

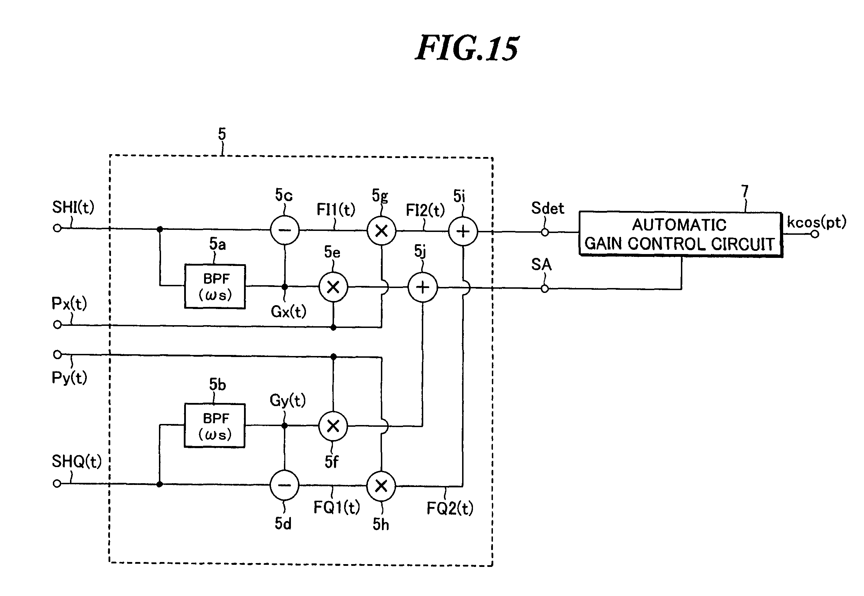

Now, with reference to Fig. 15, a description will be made to another example of the demodulator means 5 described in relation to the first to fourth embodiments. Note that in Fig. 15, the components which are the same as or equivalent to those of Fig. 14 are indicated with the same symbols.
The demodulator means 5 of this example is configured to include the band-pass filters 5a and 5b, the subtractors 5c and 5d, multipliers 5e to 5h, and adders 5i and 5j. The demodulator means 5 receives the regenerated-modulated signals SHI(t) and SHQ(t) and the oscillated signals Px (t) and Py (t), and then performs a predetermined arithmetic operation to thereby produce the demodulated signal Sdet and the gain signal SA indicative of the gain of the demodulated signal Sdet. Furthermore, the demodulator means 5 is also connected with the automatic gain control circuit 7.
The band-pass filters 5a and 5b are formed of a band-pass filter having a center angular frequency set at ωs. The band-pass filter 5a extracts from the regenerated-modulated signal SHI (t) its carrier component Gx(t), while the band-pass filter 5b extracts from the regenerated-modulated signal SHQ(t) its carrier component Gy(t).
The subtractor 5c subtracts the carrier component Gx (t) from the regenerated-modulated signal SHI(t), thereby producing a signal FI1(t) expressed by Equation (15a) below. The multiplier 5g multiplies the signal FI1(t) by the oscillated signal Px(t), thereby producing a signal FI2(t) expressed by Equation (15b) below.
[Equation 15]

$$FI1(t) = SHI(t) - Gx(t)$$
$$= 0.5 \times f(t) \times \cos(\omega_s t) - 0.5 \times A \times \cos(\omega_s t)$$
$$= 0.5 \times A \times k \cos(pt) \times \cos(\omega_s t) \qquad \cdots (15a)$$

$$FI2(t) = FI1(t) \times Px(t)$$
$$= 0.5 \times A \times k \cos(pt) \times \cos(\omega_s t) \times \cos(\omega_s t)$$
$$= 0.5 \times A \times k \cos(pt) \times \{\cos(\omega_s t)\}^2 \qquad \cdots (15b)$$

The subtractor 5d subtracts the carrier component Gy(t) from the regenerated-modulated signal SHQ(t), thereby producing a signal FQ1(t) expressed by Equation (16a) below. The multiplier 5h multiplies the signal FQ1(t) by the oscillated signal Py(t), thereby producing a signal FQ2(t) expressed by Equation (16b) below.
[Equation 16]

$$FQ1(t) = SHQ(t) - Gy(t)$$
$$= 0.5 \times f(t) \times \sin(\omega_s t) - 0.5 \times A \times \sin(\omega_s t)$$
$$= 0.5 \times A \times k \cos(pt) \times \sin(\omega_s t) \qquad \cdots (16a)$$

$$FQ2(t) = FQ1(t) \times Py(t)$$
$$= 0.5 \times A \times k \cos(pt) \times \sin(\omega_s t) \times \sin(\omega_s t)$$
$$= 0.5 \times A \times k \cos(pt) \times \{\sin(\omega_s t)\}^2 \qquad \cdots (16b)$$

The adder 5j adds the signals FI2(t) and FQ2(t), thereby producing the demodulated signal Sdet expressed by Equation (17) below.
[Equation 17]

$$Sdet = FI2(t) + FQ2(t) = 0.5 \times A \times k \cos(pt) \qquad \cdots (17)$$

The multiplier 5e multiplies the carrier component Gx(t) by the oscillated signal Px(t), while the multiplier 5f multiplies the carrier component Gy(t) by the oscillated signal Py(t). Then, the adder 5i adds the outputs of the multipliers 5e and 5f, thereby producing the gain signal SA indicative of the gain of the demodulated signal Sdet expressed by Equation (18) below.
[Equation 18]

$$\mathrm{S\,A} = \mathrm{G_x(t)} \times \mathrm{P_x(t)} + \mathrm{G_y(t)} \times \mathrm{P_y(t)}$$
$$= 0.5 \times \mathrm{A} \times \{\cos(\omega_s t)\}^2 + 0.5 \times \mathrm{A} \times \{\sin(\omega_s t)\}^2$$
$$= 0.5 \times \mathrm{A} \qquad\qquad\qquad \cdots (18)$$

The automatic gain control circuit 7 divides the demodulated signal Sdet by the gain signal SA, thereby producing for output the demodulated signal (kcos(pt)) immune to, for example, variations in receive sensitivity.

As described above, the demodulator means 5 of this example can produce the demodulated signal Sdet from the regenerated-modulated signals SHI (t) and SHQ(t) as well as the gain signal SA for the automatic gain control circuit 7 to provide automatic gain control.

Furthermore, as shown in Equations (13c) and (14) above, the demodulator means 5 shown in Fig. 14 produces the gain of the demodulated signal Sdet and the gain signal SA indicative of the gain of the demodulated signal Sdet as a squared value ($A^2$). In contrast, as shown in Equations (17) and (18), the demodulator means 5 of this example shown in Fig. 15 produces the gain of the demodulated signal Sdet and the gain signal SA indicative of the gain of the demodulated signal Sdet as a value to the power of one. It is thus possible to improve and maintain signal accuracy in demodulation as well as increase processing speeds and reduce error rates in the automatic gain control circuit 7.

Furthermore, the regenerated-modulated signals SHI(t) and SHQ(t) have the carrier component at the angular frequency $\omega_s$ with no frequency shift, frequency variation, and phase variation. It is thus possible to fix the center angular frequency of the band-pass filters 5a and 5b to the angular frequency $\omega_s$. That is, it is possible to form the band-pass filters 5a and 5b of a band-pass filter having a fixed characteristic.

Furthermore, in AM synchronous detection, this example is configured as shown in Fig. 15 to frequency convert the regenerated-modulated signals SHI(t) and SHQ(t) into a baseband frequency region and thereby produce the demodulated signal Sdet based on the oscillated signals Px(t) and Py(t), which have no noise and are produced in the oscillation means 6 provided within the receiver. It is thus possible to increase the S/N of the demodulated signal Sdet and the demodulated signal (kcos(pt)).

**Claims**

1. A receiver (100) for performing synchronous detection of a modulated signal (Sin), the receiver comprising:

   orthogonal signal generation means (1) for producing, from said modulated signal (Sin), a first signal (SI) and a second signal (SQ) having phases orthogonal to each other; and
   carrier generation means (2) for producing a trigonometric ratio of said first signal (SI) and said second signal (SQ) and for detecting at least one sign of said first signal and said second signal, so that said trigonometric ratio and said sign are used to produce a first regenerated carrier signal (SCI) and a second regenerated carrier (SCQ) signal having phases orthogonal to each other;
   and **characterised by** further comprising:

   frequency shifter means (3) for shifting said first and second regenerated carrier signals (SCI,SCQ) by a predetermined angular frequency to produce a first shifted signal (PI) and a second shifted signal (PQ); and
   combiner means (4) for combining said first signal (SI), said second signal (SQ), and said first and second shifted signals (PI, PQ), thereby converting each carrier component of said first signal and said second signal to a carrier at said predetermined angular frequency to produce a first regenerated-modulated signal (SHI) and a second regenerated-modulated signal (SHQ), wherein
   said synchronous detection is performed based on said first and second regenerated-modulated signals (SHI,SHQ).

2. A receiver (100) for performing synchronous detection of a modulated signal (Sin), the receiver comprising:

   orthogonal signal generation means (1) for producing, from said modulated signal (Sin), a first signal (SI) and a second signal (SQ) having phases orthogonal to each other;
   frequency shifter means (3) for shifting said first signal (SI) and said second signal (SQ) by a predetermined angular frequency to produce a first shifted signal (SPI) and a second shifted signal (SPQ);

carrier generation means (2) for producing a trigonometric ratio of said first and second shifted signals (SPI, SPQ) and for detecting at least one sign of said first and second shifted signals, so that said trigonometric ratio and said sign are used to produce a first regenerated carrier signal (PCI) and a second regenerated carrier signal (PCQ) having phases orthogonal to each other; and

combiner means (4) for combining said first signal (SI), said second signal (SQ), and said first and second regenerated carrier signals (PCI, PCQ), thereby converting each carrier component of said first signal and said second signal to a carrier at said predetermined angular frequency to produce a first regenerated-modulated signal (SHI) and a second regenerated-modulated signal (SHQ), wherein

said synchronous detection is performed based on said first and second regenerated-modulated signals (SHI, SHQ).

3. A receiver (100) for performing synchronous detection of a modulated signal (Sin), the receiver comprising:

orthogonal signal generation means (1) for producing, from said modulated signal (Sin), a first signal (SI) and a second signal (SQ) having phases orthogonal to each other; and

carrier generation means (2) for producing a trigonometric ratio of said first signal (SI) and said second signal (SQ) and for detecting at least one sign of said first signal and said second signal, so that said trigonometric ratio and said sign are used to produce a first regenerated carrier signal (SCI) and a second regenerated carrier signal (SCQ) having phases orthogonal to each other;

**characterised by** further comprising:

frequency shifter means (3) for shifting said first signal (SI) and said second signal (SQ) by a predetermined angular frequency to produce a first shifted signal (SPI) and a second shifted signal (SPQ); and

combiner means (4) for combining said first and second shifted signals (SPI, SPQ), and said first and second regenerated carrier signals (SCI, SCQ), thereby converting each carrier component of the first and second shifted signals (SPI, SPQ) to a carrier at said predetermined angular frequency to produce a first regenerated-modulated signal (SHI) and a second regenerated-modulated signal (SHQ), wherein

said synchronous detection is performed based on said first and second regenerated-modulated signals (SHI,SHQ).

4. A receiver (100) for performing synchronous detection of a modulated signal (Sin), the receiver comprising:

orthogonal signal generation means (1) for producing, from said modulated signal (Sin), a first signal (SI) and a second signal (SQ) having phases orthogonal to each other; and

carrier generation means (2) for producing a trigonometric ratio of said first signal (SI) and said second signal (SQ) and for detecting at least one sign of said first signal and said second signal, so that said trigonometric ratio and said sign are used to produce a first regenerated carrier signal (SCI) and a second regenerated carrier (SCQ) signal having phases orthogonal to each other;

**characterised by** further comprising:

combiner means (4) for combining said first signal (SI), said second signal (SQ), and said first and second regenerated carrier signals (SCI, SCQ), thereby producing an envelope signal (E) indicative of an envelope of a combined component of said first signal and the second signal; and

frequency shifter means (3) for modulating said envelope signal (E) based on signals having a predetermined angular frequency and having phases orthogonal to each other, thereby producing a first regenerated-modulated signal (SHI) and a second regenerated-modulated signal (SHQ), wherein

said synchronous detection is performed based on said first and second regenerated-modulated signals (SHI,SHQ).

5. The receiver according to any one of claims 1 to 3, wherein said frequency shifter means (3) performs an arithmetic operation following a predetermined algorithm using the addition theorem for the trigonometric functions, thereby producing said first shifted signal (SPI) and said second shifted signal (SPQ).

6. The receiver according to any one of claims 1 to 3, wherein said combiner means (4) performs an arithmetic operation following a predetermined algorithm using the addition theorem for the trigonometric functions, thereby producing said first regenerated-modulated signal (SHI) and said second regenerated-modulated signal (SHQ).

**7.** The receiver according to claim 4, wherein said combiner means (4) performs an arithmetic operation following a predetermined algorithm using the addition theorem for the trigonometric functions, thereby producing said envelope signal (E).

**8.** The receiver according to any one of claims 1 to 7, further comprising demodulator means (5) having first filter means (5a) for extracting a carrier component (Gx) of said first regenerated-modulated signal (SHI) and second filter means (5b) for extracting a carrier component (Gy) of said second regenerated-modulated signal (SHQ), said demodulator means (5) demodulating said first and second regenerated-modulated signals (SHI,SHQ) based on said carrier components (Gx, Gy) to thereby produce a demodulated signal (Sdet).

**9.** The receiver according to any one of claims 1 to 7, further comprising demodulator means (5) having first filter means (5a) for extracting a carrier component (Gx) of said first regenerated-modulated signal (SHI) and second filter means (5b) for extracting a carrier component (Gy) of said second regenerated-modulated signal (SHQ), said demodulator means (5) demodulating said first and second regenerated-modulated signals (SHI,SHQ) based on said carrier component (Gx,Gy) and a signal set at said predetermined angular frequency (Px, Py) to thereby produce a demodulated signal (Sdet).

**10.** The receiver according to claim 8 or 9, wherein a center angular frequency of said first and second filter means (5a, 5b) is set at said predetermined angular frequency.

**11.** The receiver according to any one of claims 8 to 10, wherein said demodulator means (5) includes computing means for combining said carrier components extracted by said first and the second filter means (5a, 5b), thereby producing a gain signal (SA) indicative of a gain of said demodulated signal (Sdet).

**12.** The receiver according to any one of claims 8 to 10, wherein said demodulator means (5) includes computing means for combining said carrier components (Gx, Gy) extracted by said first and second filter means (5a, 5b) and a signal set at said predetermined angular frequency (Px, Py), thereby producing a gain signal (SA) indicative of a gain of said demodulated signal (Sdet).

**13.** The receiver according to claim 11 or 12, further comprising automatic gain control means (7) for providing automatic gain control to said demodulated signal (Sdet) based on said gain signal (SA).

**Patentansprüche**

**1.** Empfänger (100) zum Durchführen einer synchronen Erfassung eines modulierten Signals (Sin), wobei der Empfänger enthält: '
ein Orthogonalsignal-Erzeugungselement (1) zum Erzeugen, aus dem modulierten Signal (Sin), eines ersten Signals (SI) und eines zweiten Signals (SQ), welche zueinander orthogonale Phasen haben; und
ein Träger-Erzeugungselement (2) zum Erzeugen eines trigonometrischen Verhältnisses aus dem ersten Signal (SI) und dem zweiten Signal (SQ), und zum Erfassen von zumindest einem Vorzeichen des ersten Signals und des zweiten Signals, so dass das trigonometrische Verhältnis und das Vorzeichen dazu verwendet werden, ein erstes regeneriertes Trägersignal (SCI) und ein zweites regeneriertes Trägersignal (SCQ) zu erzeugen, welche zueinander orthogonale Phasen haben;
und **gekennzeichnet durch**:

ein Frequenz-Verschiebungselement (3) zum Verschieben des ersten und zweiten regenerierten Trägersignals (SCI, SCQ) um eine vorbestimmte Winkelfrequenz, um ein erstes verschobenes Signal (PI) und ein zweites verschobenes Signal (PQ) zu erzeugen; und
ein Zusammenfassungs-Element (4) zum Zusammenfassen des ersten Signals (SI), des zweiten Signals (SQ) und des ersten und zweiten verschobenen Signals (PI, PQ), wodurch jede Trägerkomponente des ersten Signals und des zweiten Signals auf einen Träger bei der vorbestimmten Winkelfrequenz umgewandelt wird, um ein erstes regeneriertes moduliertes Signal (SHI) und ein zweites regeneriertes moduliertes Signal (SHQ) zu erzeugen, wobei
die synchrone Erfassung basierend auf dem ersten und zweiten regenerierten modulierten Signal (SHI, SHQ) durchgeführt wird.

**2.** Empfänger (100) zum Durchführen von einer synchronen Erfassung eines modulierten Signals (Sin), wobei der Empfänger enthält:

ein Orthogonalsignal-Erzeugungselement (1) zum Erzeugen, aus dem modulierten Signal (Sin), eines ersten Signals (SI) und eines zweiten Signals (SQ), welche zueinander orthogonale Phasen haben;

ein Frequenz-Verschiebungselement (3) zum Verschieben des ersten Signals (SI) und des zweiten Signals (SQ) um eine vorbestimmte Winkelfrequenz, um ein erstes verschobenes Signal (SPI) und ein zweites verschobenes Signal (SPQ) zu erzeugen;

ein Träger-Erzeugungselement (2) zum Erzeugen eines trigonometrischen Verhältnisses des ersten und zweiten verschobenen Signals (SPI, SPQ), und zum Erfassen von zumindest einem Vorzeichen des ersten und zweiten verschobenen Signals, so dass das trigonometrische Verhältnis und das Vorzeichen dazu verwendet werden, um ein erstes regeneriertes Trägersignal (PCI) und ein zweites regeneriertes Trägersignal (PCQ) zu erzeugen, welche zueinander orthogonale Phasen haben; und

ein Zusammenfassungs-Element (4) zum Zusammenfassen des ersten Signals (SI), des zweiten Signals (SQ) und des ersten und zweiten regenerierten Trägersignals (PCI, PCQ), wodurch jede Trägerkomponente des ersten Signals und des zweiten Signals auf einen Träger bei der vorbestimmten Winkelfrequenz umgewandelt wird, um ein erstes regeneriertes moduliertes Signal (SHI) und ein zweites regeneriertes moduliertes Signal (SHQ) zu erzeugen, wobei die synchrone Erfassung basierend auf dem ersten und zweiten regenerierten modulierten Signal (SHI, SHQ) durchgeführt wird.

3.  Empfänger (100) zum Durchführen von einer synchronen Erfassung eines modulierten Signals (Sin), wobei der Empfänger enthält:

ein Orthogonalsignal-Erzeugungselement (1) zum Erzeugen, aus dem modulierten Signal (Sin), eines ersten Signals (SI) und eines zweiten Signals (SQ), welche zueinander orthogonale Phasen haben; und

ein Träger-Erzeugungselement (2) zum Erzeugen eines trigonometrischen Verhältnisses des ersten Signals (SI) und des zweiten Signals (SQ), und zum Erfassen von zumindest einem Vorzeichen des ersten Signals und des zweiten Signals, so dass das trigonometrische Verhältnis und das Vorzeichen dazu verwendet werden, um ein erstes regeneriertes Trägersignal (SCI) und ein zweites regeneriertes Trägersignal (SCQ) zu erzeugen, welche zueinander orthogonale Phasen haben;

**gekennzeichnet durch**:

ein Frequenz-Verschiebungselement (3) zum Verschieben des ersten Signals (SI) und des zweiten Signals (SQ) um eine vorbestimmte Winkelfrequenz, um ein erstes verschobenes Signal (SPI) und ein zweites verschobenes Signal (SPQ) zu erzeugen; und

ein Zusammenfassungs-Element (4) zum Zusammenfassen des ersten und zweiten verschobenen Signals (SPI, SPQ) und des ersten und zweiten regenerierten Trägersignals (SCI, SCQ), wodurch jede Trägerkomponente des ersten und zweiten verschobenen Signals (SPI, SPQ) auf einen Träger auf der vorbestimmten Winkelfrequenz umgewandelt wird, um ein erstes regeneriertes moduliertes Signal (SHI) und ein zweites regeneriertes moduliertes Signal (SHQ) zu erzeugen, wobei

die synchrone Erfassung basierend auf dem ersten und zweiten regenerierten modulierten Signal (SHI, SHQ) durchgeführt wird.

4.  Empfänger (100) zum Durchführen von einer synchronen Erfassung eines modulierten Signals (Sin), wobei der Empfänger enthält:

ein Orthogonalsignal-Erzeugungselement (1) zum Erzeugen, aus dem modulierten Signal (Sin), eines ersten Signals (SI) und eines zweiten Signals (SQ), welche zueinander orthogonale Phasen haben; und

ein Träger-Erzeugungselement (2) zum Erzeugen eines trigonometrischen Verhältnisses des ersten Signals (SI) und des zweiten Signals (SQ), und zum Erfassen von zumindest einem Vorzeichen von dem ersten Signal und dem zweiten Signal, so dass das trigonometrische Verhältnis und das Vorzeichen dazu verwendet werden, ein erstes regeneriertes Trägersignal (SCI) und ein zweites regeneriertes Trägersignal (SCQ) zu erzeugen, welche zueinander orthogonale Phasen haben;

**gekennzeichnet durch**:

ein Zusammenfassungs-Element (4) zum Zusammenfassen des ersten Signals (SI) und des zweiten Signals (SQ) und des ersten und zweiten regenerierten Trägersignals (SCI, SCQ), wodurch ein Hüllsignal (E) erzeugt wird, welches auf eine Einhüllende von einer zusammengefassten Komponente des ersten Signals und des zweiten Signals hinweist; und

ein Frequenzverschiebungs-Element (3) zum Modulieren des Hüllsignals (E) basierend auf Signale, welche eine vorbestimmte Winkelfrequenz haben und zueinander orthogonale Phasen haben, wodurch ein erstes regeneriertes moduliertes Signal (SHI) und ein zweites regeneriertes moduliertes Signal (SHQ) erzeugt werden, wobei

die Synchronität-Erfassung basierend auf dem ersten und zweiten regenerierten modulierten Signal (SHI, SHQ) durchgeführt wird.

5. Empfänger nach einem der Ansprüche 1 bis 3, bei welchem das Frequenzverschiebungs-Element (3) einen arithmetischen Betrieb, einem vorbestimmten Algorithmus folgend unter Verwendung des Additionstheorems für die trigonometrischen Funktionen durchführt, wodurch das erste verschobene Signal (SPI) und das zweite verschobene Signal (SPQ) erzeugt werden.

6. Empfänger nach einem der Ansprüche 1 bis 3, bei welchem das Zusammenfassungs-Element (4) einen arithmetischen Betrieb, einem vorbestimmten Algorithmus folgend unter Verwendung des Additionstheorems für die trigonometrischen Funktionen durchführt, wodurch das erste regenerierte modulierte Signal (SHI) und das zweite regenerierte modulierte Signal (SHQ) erzeugt werden.

7. Empfänger nach Anspruch 4, bei welchem das Zusammenfassungs-Element (4) einen arithmetischen Betrieb, einem vorbestimmten Algorithmus folgend unter Verwendung des Additionstheorems für die trigonometrischen Funktionen durchführt, wodurch das Hüllsignal (E) erzeugt wird.

8. Empfänger nach einem der Ansprüche 1 bis 7, welcher ferner ein Demodulations-Element (5) enthält, welches ein erstes Filterelement (5a) zum Extrahieren einer Trägerkomponente (Gx) des ersten regenerierten modulierten Signals (SHI), und ein zweites Filterelement (5b) zum Extrahieren einer Trägerkomponente (Gy) des zweiten regenerierten modulierten Signals (SHQ) hat, wobei das Demodulations-Element (5) das erste und zweite regenerierte modulierte Signal (SHI, SHQ) basierend auf den Trägerkomponenten (Gx, Gy) demoduliert, um somit ein demoduliertes Signal (Sdet) zu erzeugen.

9. Empfänger nach einem der Ansprüche 1 bis 7, welcher ferner ein Demodulations-Element (5) enthält, welches ein erstes Filterelement (5a) zum Extrahieren einer Trägerkomponente (Gx) des ersten regenerierten modulierten Signals (SHI), und ein zweites Filterelement (5b) zum Extrahieren einer Trägerkomponente (Gy) des zweiten regenerierten modulierten Signals (SHQ) hat, wobei das Demodulations-Element (5) das erste und zweite regenerierte modulierte Signal (SHI, SHQ) basierend auf den Trägerkomponenten (Gx, Gy) und ein Signal, welches auf die vorbestimmte Winkelfrequenz (Px, Py) eingestellt ist, demoduliert, um somit ein demoduliertes Signal (Sdet) zu erzeugen.

10. Empfänger nach Anspruch 8 oder 9, bei welchem eine Mitten-Winkelfrequenz des ersten und zweiten Filterelements (5a, 5b) auf die vorbestimmte Winkelfrequenz eingestellt ist.

11. Empfänger nach einem der Ansprüche 8 bis 10, bei welchem das Demodulations-Element (5) ein Berechnungselement zum Zusammenfassen der Trägerkomponenten enthält, welche durch das erste und das zweite Filterelement (5a, 5b) extrahiert sind, wodurch ein Verstärkungssignal (SA) erzeugt wird, welches auf eine Verstärkung des demodulierten Signals (Sdet) hinweist.

12. Empfänger nach einem der Ansprüche 8 bis 10, bei welchem das Demodulations-Element (5) ein Berechnungselement zum Zusammenfassen der Trägerkomponenten (Gx, Gy), welche durch das erste und zweite Filterelement (5a, 5b) extrahier sind, und eines Signals, welches auf die vorbestimmte Winkelfrequenz (Px, Py) eingestellt ist, enthält, wodurch ein Verstärkungssignal (SA) erzeugt wird, welches auf eine Verstärkung des demodulierten Signals (Sdet) hinweist.

13. Empfänger nach Anspruch 11 oder 12, welcher ferner ein Automatik-Verstärkungs-Steuerelement (7) zur Bereitstellung einer Automatik-Verstärkungssteuerung auf das demodulierte Signal (Sdet) basierend auf dem Verstärkungssignal (SA) enthält.

**Revendications**

1. Récepteur (100) pour effectuer la détection synchrone d'un signal modulé (Sin), le récepteur comprenant :

des moyens de génération de signal orthogonal (1) pour produire, à partir dudit signal modulé (Sin), un premier signal (SI) et un deuxième signal (SQ) ayant des phases mutuellement orthogonales ; et

des moyens de génération de porteuse (2) pour produire un rapport trigonométrique dudit premier signal (SI) et dudit deuxième signal (SQ) et pour détecter au moins un signe dudit premier signal et dudit deuxième signal, de sorte que ledit rapport trigonométrique et ledit signe soient utilisés pour produire un premier signal de porteuse régénéré (SCI) et un deuxième signal de porteuse régénéré (SCQ) ayant des phases mutuellement orthogonales ;

et **caractérisé en ce qu'**il comprend en outre :

des moyens de déplacement de fréquence (3) pour déplacer lesdits premier et deuxième signaux de porteuse régénérés (SCI, SCQ) d'une fréquence angulaire prédéterminée pour produire un premier signal déplacé (PI) et un deuxième signal déplacé (PQ) ; et

des moyens de combineur (4) pour combiner ledit premier signal (SI), ledit deuxième signal (SQ), et lesdits premier et deuxième signaux déplacés (PI, PQ), de manière à convertir chaque composante de porteuse dudit premier signal et dudit deuxième signal en une porteuse à ladite fréquence angulaire prédéterminée pour produire un premier signal régénéré-modulé (SHI) et un deuxième signal régénéré-modulé (SHQ), où ladite détection synchrone est effectuée sur la base desdits premier et deuxième signaux régénérés-modulés (SHI, SHQ).

2. Récepteur (100) pour effectuer la détection synchrone d'un signal modulé (Sin), le récepteur comprenant :

des moyens de génération de signal orthogonal (1) pour produire, à partir dudit signal modulé (Sin), un premier signal (SI) et un deuxième signal (SQ) ayant des phases mutuellement orthogonales ;

des moyens de déplacement de fréquence (3) pour déplacer ledit premier signal (SI) et déplacer ledit deuxième signal (SQ) d'une fréquence angulaire prédéterminée pour produire un premier signal déplacé (SPI) et un deuxième signal déplacé (SPQ) ;

des moyens de génération de porteuse (2) pour produire un rapport trigonométrique desdits premier et deuxième signaux déplacés (SPI, SPQ) et pour détecter au moins un signe desdits premier et deuxième signaux déplacés, de sorte que ledit rapport trigonométrique et ledit signe soient utilisés pour produire un premier signal de porteuse régénéré (PCI) et un deuxième signal de porteuse régénéré (PCQ) ayant des phases mutuellement orthogonales ; et

des moyens de combineur (4) pour combiner ledit premier signal (SI), ledit deuxième signal (SQ), et lesdits premier et deuxième signaux de porteuse régénérés (PCI, PCQ), de manière à convertir chaque composante de porteuse dudit premier signal et dudit deuxième signal en une porteuse à ladite fréquence angulaire prédéterminée pour produire un premier signal régénéré-modulé (SHI) et un deuxième signal régénéré-modulé (SHQ), où

ladite détection synchrone est effectuée sur la base desdits premier et deuxième signaux régénérés-modulés (SHI, SHQ).

3. Récepteur (100) pour effectuer la détection synchrone d'un signal modulé (Sin), le récepteur comprenant :

des moyens de génération de signal orthogonal (1) pour produire, à partir dudit signal modulé (Sin), un premier signal (SI) et un deuxième signal (SQ) ayant des phases mutuellement orthogonales ; et

des moyens de génération de porteuse (2) pour produire un rapport trigonométrique dudit premier signal (SI) et dudit deuxième signal (SQ) et pour détecter au moins un signe dudit premier signal et dudit deuxième signal, de sorte que ledit rapport trigonométrique et ledit signe soient utilisés pour produire un premier signal de porteuse régénéré (SCI) et un deuxième signal de porteuse régénéré (SCQ) ayant des phases mutuellement orthogonales ;

**caractérisé en ce qu'**il comprend en outre :

des moyens de déplacement de fréquence (3) pour déplacer ledit premier signal (SI) et ledit deuxième signal (SQ) d'une fréquence angulaire prédéterminée pour produire un premier signal déplacé (SPI) et un deuxième signal déplacé (SPQ) ; et

des moyens de combineur (4) pour combiner lesdits premier et deuxième signaux déplacés (SPI, SPQ), et lesdits premier et deuxième signaux de porteuse régénérés (SCI, SCQ), de manière à convertir chaque composante de porteuse des premier et deuxième signaux déplacés (SPI, SPQ) en une porteuse à ladite fréquence angulaire prédéterminée pour produire un premier signal régénéré-modulé (SHI) et un deuxième signal régénéré-modulé (SHQ), où

ladite détection synchrone est effectuée sur la base desdits premier et deuxième signaux régénérés-modulés (SHI, SHQ).

4. Récepteur (100) pour effectuer la détection synchrone d'un signal modulé (Sin), le récepteur comprenant :

des moyens de génération de signal orthogonal (1) pour produire, à partir dudit signal modulé (Sin), un premier signal (SI) et un deuxième signal (SQ) ayant des phases mutuellement orthogonales ; et
des moyens de génération de porteuse (2) pour produire un rapport trigonométrique dudit premier signal (SI) et dudit deuxième signal (SQ) et pour détecter au moins un signe dudit premier signal et dudit deuxième signal, de sorte que ledit rapport trigonométrique et ledit signe soient utilisés pour produire un premier signal de porteuse régénéré (SCI) et un deuxième signal de porteuse régénéré (SCQ) ayant des phases mutuellement orthogonales ;
**caractérisé en ce qu'**il comprend en outre :

des moyens de combineur (4) pour combiner ledit premier signal (SI), ledit deuxième signal (SQ), et lesdits premier et deuxième signaux de porteuse régénérés (SCI, SCQ), de manière à produire un signal d'enveloppe (E) indicatif d'une enveloppe d'une composante combinée dudit premier signal et du deuxième signal ; et
des moyens de déplacement de fréquence (3) pour moduler ledit signal d'enveloppe (E) sur la base de signaux ayant une fréquence angulaire prédéterminée et ayant des phases mutuellement orthogonales, de manière à produire un premier signal régénéré-modulé (SHI) et un deuxième signal régénéré-modulé (SHQ), où
ladite détection synchrone est effectuée sur la base desdits premier et deuxième signaux régénérés-modulés (SHI, SHQ).

5. Récepteur selon l'une quelconque des revendications 1 à 3, où lesdits moyens de déplacement de fréquence (3) effectuent une opération arithmétique selon un algorithme prédéterminé en utilisant le théorème d'addition pour les fonctions trigonométriques, de manière à produire ledit premier signal déplacé (SPI) et ledit deuxième signal déplacé (SPQ).

6. Récepteur selon l'une quelconque des revendications 1 à 3, dans lequel lesdits moyens de combineur (4) effectuent une opération arithmétique selon un algorithme prédéterminé en utilisant le théorème d'addition pour les fonctions trigonométriques, de manière à produire ledit premier signal régénéré-modulé (SHI) et ledit deuxième signal régénéré-modulé (SHQ).

7. Récepteur selon la revendication 4, dans lequel lesdits moyens de combineur (4) effectuent une opération arithmétique selon un algorithme prédéterminé en utilisant le théorème d'addition pour les fonctions trigonométriques, de manière à produire ledit signal d'enveloppe (E).

8. Récepteur selon l'une quelconque des revendications 1 à 7, comprenant en outre des moyens de démodulateur (5) ayant des premiers moyens de filtre (5a) pour extraire une composante de porteuse (Gx) dudit premier signal régénéré-modulé (SHI) et des deuxièmes moyens de filtre (5b) pour extraire une composante de porteuse (Gy) dudit deuxième signal régénéré-modulé (SHQ), lesdits moyens de démodulateur (5) démodulant lesdits premier et deuxième signaux régénérés-modulés (SHI, SHQ) sur la base desdites composantes de porteuse (Gx, Gy) de manière à produire un signal démodulé (Sdet).

9. Récepteur selon l'une quelconque des revendications 1 à 7, comprenant en outre des moyens de démodulateur (5) ayant des premiers moyens de filtre (5a) pour extraire une composante de porteuse (Gx) dudit premier signal régénéré-modulé (SHI) et des deuxièmes moyens de filtre (5b) pour extraire une composante de porteuse (Gy) dudit deuxième signal régénéré-modulé (SHQ), lesdits moyens de démodulateur (5) démodulant lesdits premier et deuxième signaux régénérés-modulés (SHI, SHQ) sur la base de ladite composante de porteuse (Gx, Gy) et un signal défini à une première fréquence angulaire prédéterminée (Px, Py) de manière à produire un signal démodulé (Sdet).

10. Récepteur selon la revendication 8 ou 9, dans lequel une fréquence angulaire centrale desdits premier et deuxième moyens de filtre (5a, 5b) est définie à ladite fréquence angulaire prédéterminée.

11. Récepteur selon l'une quelconque des revendications 8 à 10, dans lequel lesdits moyens de démodulateur (5) comprennent des moyens de calcul pour combiner lesdites composantes de porteuse extraites par lesdits premier et deuxième moyens de filtre (5a, 5b), de manière à produire un signal de gain (SA) indicatif d'un gain dudit signal démodulé (Sdet).

12. Récepteur selon l'une quelconque des revendications 8 à 10, dans lequel lesdits moyens de démodulateur (5) comprennent des moyens de calcul pour combiner lesdites composantes de porteuse (Gx, Gy) extraites par lesdits premier et deuxième moyens de filtre (5a, 5b) et un signal défini à ladite fréquence angulaire prédéterminée (Px, Py), de manière à produire un signal de gain (SA) indicatif d'un gain dudit signal démodulé (Sdet).

13. Récepteur selon la revendication 11 ou 12, comprenant en outre des moyens de commande de gain automatique (7) pour effectuer une commande de gain automatique dudit signal démodulé (Sdet) sur la base dudit signal de gain (SA).

# FIG.1

IF SIGNAL
(INPUT)

MIXER

VOLTAGE
CONTROLLED
OSCILLATOR
(VCO)

LOOP FILTER

BANDWIDTH LIMITING
LOW-PASS FILTER

DEMODULATED SIGNAL
(OUTPUT)

PRIOR ART

EP 1 988 639 B1

# FIG.2 (a)

# FIG.2 (b)

# FIG.3 (a)

# FIG.3 (b)

# FIG.4

$$\begin{cases} Sx(t)=\cos(\omega rt) & Px(t)=\cos(\omega st) \\ Sy(t)=\cos(\omega rt+\pi/2) & Py(t)=\sin(\omega st) \end{cases}$$

*FIG.5*

EP 1 988 639 B1

## FIG.6 (a)

## FIG.6 (b)

## FIG.6 (c)

[STEPS FOR PRODUCING PHASE $\Phi$ (t) FROM TANGENT TRIGONOMETRIC RATIO R]

GI(*),
GQ(*) [SIGN DETERMINATION] [REGION DETERMINATION] [PHASE CORRECTION]

GI(+), GQ(+) ⟶ $\left(\begin{array}{l}\text{FIRST QUADRANT}\\ 0 \sim \pi/2\end{array}\right)$ ⟶ $\phi(t) = \alpha(t)$

GI(−), GQ(+) ⟶ $\left(\begin{array}{l}\text{SECOND QUADRANT}\\ \pi/2 \sim \pi\end{array}\right)$ ⟶ $\phi(t) = \pi - |\alpha(t)|$

GI(−), GQ(−) ⟶ $\left(\begin{array}{l}\text{THIRD QUADRANT}\\ \pi \sim 3\pi/2\end{array}\right)$ ⟶ $\phi(t) = \pi + |\alpha(t)|$

GI(+), GQ(−) ⟶ $\left(\begin{array}{l}\text{FOURTH QUADRANT}\\ 3\pi/2 \sim 2\pi\end{array}\right)$ ⟶ $\phi(t) = 2\pi - |\alpha(t)|$

*FIG.7*

EP 1 988 639 B1

# FIG.8

# FIG.9

IN(t)
「SI(t) or SPI(t)」

INQ(t)
「SQ(t) or SPQ(t)」

2a — RATIO GENERATOR SECTION

R

2c — INVERSE TRIGONOMETRIC OPERATION SECTION

$\alpha$(t)

2d — PHASE GENERATOR SECTION

XCI(t)

2e — REGENERATED CARRIER GENERATION SECTION

OUTI(t)
「SCI(t) or PCI(t)」

OUTQ(t)
「SCQI(t) or PCQ(t)」

2b — SIGN DETECTOR SECTION

GQ(*)
(GI(*))

2m — $\tau$ s

2n

$\phi$(t) — $\phi$(t+ $\tau$ s)

2

*FIG.10 (a)*

f(t)

(+)

0

(-)

PLUS

PLUS

MINUS

t(TIME)

*FIG.10 (b)*

OUTI(t)
BEFORE CORRECTION

(+)

0

(-)

t(TIME)

*FIG.10 (c)*

OUTQ(t)
BEFORE CORRECTION

(+)

0

(-)

t(TIME)

*FIG.10 (d)*

OUTI(t)
AFTER CORRECTION

(+)

0

(-)

t(TIME)

*FIG.10 (e)*

OUTQ(t)
AFTER CORRECTION

(+)

0

(-)

t(TIME)

tg0                tg1                tg2

## FIG.11(a)

## FIG.11(b)

*FIG.12 (a)*

*FIG.12 (b)*

*FIG.12 (c)*

*FIG.13 (a)*

SI(t)

PI(t)
or
PCI(t)

PQ(t)
or
PCQ(t)

SCQ(t)

4a 4b 4e 4c 4f 4d

SHI(t)

SHQ(t)

*FIG.13 (b)*

SCI(t)

SPI(t)

SPQ(t)

SCQ(t)

4a 4b 4e 4c 4f 4d

SHI(t)

SHQ(t)

*FIG.13 (c)*

SI(t)

SCI(t)

SCQ(t)

SQ(t)

4x 4z

4y

E(t)

42

# FIG.14

EP 1 988 639 B1

# FIG.15

EP 1 988 639 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4635279 A

- JP 2006030991 A